# EUROPEAN PATENT APPLICATION

(11) **EP 4 770 374 A1**
(43) Date of publication of application: **01.07.2026**
(21) Application number: 24866924.4
(22) Date of filing: 05.06.2024
(51) Int. Cl.: H10K 59/126, H10K 59/124, H10K 59/131

(54) **ARRAY SUBSTRATE AND DISPLAY PANEL**

(30) Priority: 20.09.2023 CN 202311222580
(71) Applicant: Hefei Visionox Technology Co., Ltd., Hefei, Anhui 230000 (CN); Kunshan Go-Visionox Opto-Electronics Co., Ltd., Kunshan, Jiangsu 215300 (CN)
(72) Inventor: SHI, Fengbo, Suzhou, Jiangsu 215300 (CN); HE, Yanbing, Suzhou, Jiangsu 215300 (CN); XU, Ji, Suzhou, Jiangsu 215300 (CN); ZHANG, Lu, Suzhou, Jiangsu 215300 (CN); WU, Zhonghou, Suzhou, Jiangsu 215300 (CN); ZHANG, Jinfang, Suzhou, Jiangsu 215300 (CN)
(74) Representative: Lorenz Seidler Gossel Part. mbB
(86) International application number: PCT/CN2024/097446
(87) International publication number: WO 2025/060504

(57) **Abstract**

Provided are an array substrate and a display panel. The array substrate includes a substrate and a driver circuit layer located on the substrate, where a pixel circuit and a light emission control signal line are disposed in the driver circuit layer, the pixel circuit includes a drive transistor, a first initialization transistor, and a first connecting portion, the first connecting portion is connected between a first electrode of the drive transistor and the first initialization transistor, and an overlapping portion exists between an orthographic projection of the first connecting portion on the substrate and an orthographic projection of the light emission control signal line on the substrate; an orthographic projection of the shielding portion in the driver circuit layer on the substrate overlaps the overlapping portion, and a film where the shielding portion is located is between a film where the light emission control signal line is located and a film where the first connecting portion is located; and/or at least one organic insulating layer is disposed between a film where the first connecting portion is located and a film where the light emission control signal line is located; and/or the thickness of an insulating layer between a film where the first connecting portion is located and a film where the light emission control signal line is located is greater than 3 micrometers.

## Description

This application claims priority to Chinese Patent Application No. 202311222580.4 filed with the China National Intellectual Property Administration (CNIPA) on Sep. 20, 2023, the disclosure of which is incorporated herein by reference in its entirety.

### TECHNICAL FIELD

The present application relates to the field of display technologies, for example, an array substrate and a display panel.

### BACKGROUND

With the rapid development of display technologies, organic light emitting display (OLED) products have found increasingly widespread applications.

However, the display uniformity of the OLED display panel still needs to be further improved.

### SUMMARY

The present application provides an array substrate and a display panel to improve the display uniformity of the display panel.

The embodiments of the present application provide an array substrate. The array substrate includes a substrate and a driver circuit layer located on the substrate, where a pixel circuit and a light emission control signal line are disposed in the driver circuit layer, the pixel circuit includes a drive transistor, a first initialization transistor, and a first connecting portion, the first connecting portion is connected between a first electrode of the drive transistor and the first initialization transistor, and an overlapping portion exists between an orthographic projection of the first connecting portion on the substrate and an orthographic projection of the light emission control signal line on the substrate; the driver circuit layer is further provided with a shielding portion, an orthographic projection of the shielding portion on the substrate overlaps the overlapping portion, and a film where the shielding portion is located is between a film where the light emission control signal line is located and a film where the first connecting portion is located; and/or at least one organic insulating layer is disposed between a film where the first connecting portion is located and a film where the light emission control signal line is located; and/or the thickness of an insulating layer between a film where the first connecting portion is located and a film where the light emission control signal line is located is greater than 3 micrometers.

The embodiment of the present application provides a display panel, and the display panel includes the array substrate provided in any embodiment of the present application.

In the technical solutions of the embodiments of the present application, the shielding portion is provided, the orthographic projection of the shielding portion on the substrate overlaps the overlapping portion, and the film where the shielding portion is located is between the film where the light emission control signal line is located and the film where the first connecting portion is located so that the shielding portion shields the signal transmitted on the light emission control signal line, thereby eliminating or reducing the coupling degree (for example, the degree of potential pull-down) of the parasitic capacitor generated at the overlapping portion between the light emission control signal line and the first connecting portion to the potential of the first electrode of the drive transistor. In this manner, the difference in the coupling degree of the parasitic capacitor to the potential of the first electrode of the drive transistor is reduced among the pixel circuits at different positions. Therefore, the degree to which the parasitic capacitor affects the drive current is the same or substantially the same among the pixel circuits at different positions, thereby making the display brightness of the light-emitting devices at different positions tend to be consistent at the same gray level, which is conducive to improving the display uniformity of the display panel and enhancing the display effect of the display panel. At least one organic insulating layer is provided between the film where the first connecting portion is located and the film where the light emission control signal line is located so that the facing distance between the light emission control signal line and the first connecting portion is increased, and the dielectric constant of the parasitic capacitor at the overlapping portion is reduced, thereby reducing the parasitic capacitance and reducing the influence of the parasitic capacitor on the brightness of the light-emitting device, which is conducive to improving the display effect of the display panel. The thickness of the insulating layer between the film where the first connecting portion is located and the film where the light emission control signal line is located is greater than 3 micrometers so that the facing distance between the light emission control signal line and the first connecting portion is increased, thereby reducing the parasitic capacitance and reducing the influence of the parasitic capacitor on the brightness of the light-emitting device, which is conducive to improving the display effect of the display panel.

### BRIEF DESCRIPTION OF DRAWINGS

FIG. 1 is a structural diagram of a pixel circuit in the related art.
FIG. 2 is a timing diagram of a pixel circuit in the related art.
FIG. 3 is a structural view illustrating the layout of a pixel circuit in the related art.
FIG. 4 is a structural view illustrating the layout of an array substrate according to an embodiment of the present application.
FIG. 5 is a sectional view of FIG. 4 taken along a direction a0-a0'.
FIG. 6 is a structural diagram of a pixel circuit according to an embodiment of the present application.
FIG. 7 is a structural view illustrating the layout of another array substrate according to an embodiment of the present application.
FIG. 8 is a sectional view of FIG. 7 taken along a direction a1-a2.
FIG. 9 is a structural view illustrating the layout of another array substrate according to an embodiment of the present application.
FIG. 10 is a sectional view of FIG. 4 taken along a direction b1-b2.
FIG. 11 is a structural view illustrating the layout of another array substrate according to an embodiment of the present application.
FIG. 12 is a structural view illustrating the layout of another array substrate according to an embodiment of the present application.
FIG. 13 is a structural view illustrating the layout of another array substrate according to an embodiment of the present application.
FIG. 14 is a structural view illustrating the layout of another array substrate according to an embodiment of the present application.
FIG. 15 is a sectional view of FIG. 14 taken along a direction f1-f2.
FIG. 16 is a structural view illustrating the layout of another array substrate according to an embodiment of the present application.
FIG. 17 is another sectional view of FIG. 7 taken along a direction a1-a2.
FIG. 18 is a structural view illustrating the layout of another array substrate according to an embodiment of the present application.
FIG. 19 is a sectional view of FIG. 18 taken along a direction k1-k2.
FIG. 20 is a structural view illustrating the layout of a first conductive layer and a second active layer of an array substrate according to an embodiment of the present application.
FIG. 21 is a structural view illustrating the layout of a second conductive layer of an array substrate according to an embodiment of the present application.
FIG. 22 is a structural view illustrating the layout of a third conductive layer and a first active layer of an array substrate according to an embodiment of the present application.
FIG. 23 is a structural view illustrating the layout of a fourth conductive layer of an array substrate according to an embodiment of the present application.
FIG. 24 is a structural view illustrating the layout of a fourth conductive layer of another array substrate according to an embodiment of the present application.
FIG. 25 is a structural view illustrating the layout of a fifth conductive layer of an array substrate according to an embodiment of the present application.
FIG. 26 is a structural view illustrating the layout of a sixth conductive layer of an array substrate according to an embodiment of the present application.
FIG. 27 is a structural view illustrating the layout of a shielding layer of an array substrate according to an embodiment of the present application.
FIG. 28 is a structural view illustrating the layout of another array substrate according to an embodiment of the present application.
FIG. 29 is a structural view illustrating the layout of another array substrate according to an embodiment of the present application.
FIG. 30 is a structural view illustrating the layout of another array substrate according to an embodiment of the present application.
FIG. 31 is a structural diagram of another pixel circuit according to an embodiment of the present application.
FIG. 32 is a structural view illustrating the layout of another array substrate according to an embodiment of the present application.
FIG. 33 is a structural view of a display panel according to an embodiment of the present application.

### DETAILED DESCRIPTION

Terms such as "first" and "second" in the description, claims, and above drawings of the present application are used to distinguish between similar objects and are not necessarily used to describe a particular order or sequence. It is to be understood that data used in this manner are interchangeable where appropriate so that embodiments of the present application described herein can be implemented in an order not illustrated or described herein. In addition, the terms "including", "having", and any other variations thereof are intended to cover a non-exclusive inclusion. For example, a process, a method, a system, a product, or a device that includes a series of steps or units may include not only the expressly listed steps or units but also other steps or units that are not expressly listed or are inherent to the process, the method, the product, or the device.

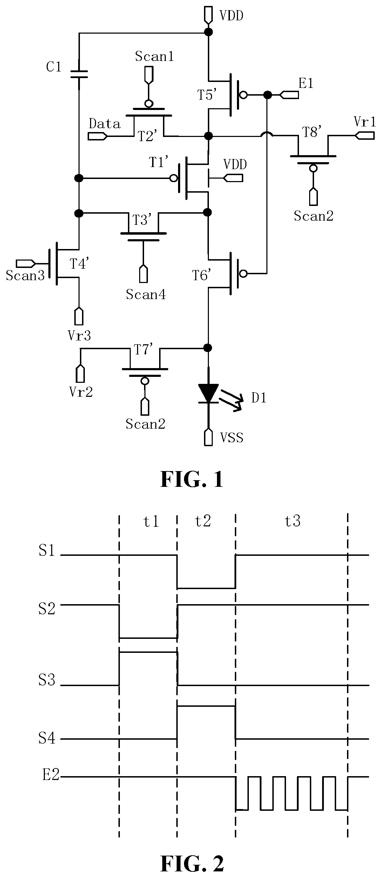

FIG. 1 is a structural diagram of a pixel circuit in the related art. As shown in FIG. 1, the pixel circuit includes a first transistor T1', a second transistor T2', a third transistor T3', a fourth transistor T4', a fifth transistor T5', a sixth transistor T6', a seventh transistor T7', an eighth transistor T8', and a first capacitor C1. FIG. 2 is a timing diagram of a pixel circuit in the related art. As shown in FIG. 2, the driving process of the pixel circuit includes an initialization stage t1, a threshold compensation and data write stage t2, and a light emission stage t3. In the initialization stage t1, a second scan signal S2 on a second scan line Scan2 is at a low level, the second scan signal S2 controls the seventh transistor T7' and the eighth transistor T8' to be turned on, a third scan signal S3 on a third scan line Scan3 is at a high level, the third scan signal S3 controls the fourth transistor T4' to be turned on, the eighth transistor T8' transmits a first reset signal transmitted on a first reset signal line Vr1 to a source of the first transistor T1' to reset the source of the first transistor T1', the seventh transistor T7' transmits a second reset signal transmitted on a second reset signal line Vr2 to an anode of a light-emitting diode D1 to reset the anode of the light-emitting diode D1, and the fourth transistor T4' transmits a third reset signal transmitted on a third reset signal line Vr3 to a gate of the first transistor T1' to reset the gate of the first transistor T1'. In the threshold compensation and data write stage t2, the first scan signal S1 on the first scan line Scan1 is at a low level, the first scan signal S1 controls the second transistor T2' to be turned on, a fourth scan signal S4 on a fourth scan line Scan4 is at a high level, the fourth scan signal S4 controls the third transistor T3' to be turned on, the data voltage transmitted on a data line Data is transmitted to the gate of the first transistor T1' through the second transistor T2', the first transistor T1', and the third transistor T3', and the third transistor T3' captures the threshold voltage of the first transistor T1', thereby achieving threshold compensation and data writing for the first transistor T1'. In the light emission stage t3, when an enable signal E2 on an enable line E1 is at a low level, the fifth transistor T5' and the sixth transistor T6' are controlled to be turned on, and the fifth transistor T5', the first transistor T1', and the sixth transistor T6' form a drive current path to provide a drive current for the light-emitting diode D1 so that the light-emitting diode D1 emits light.

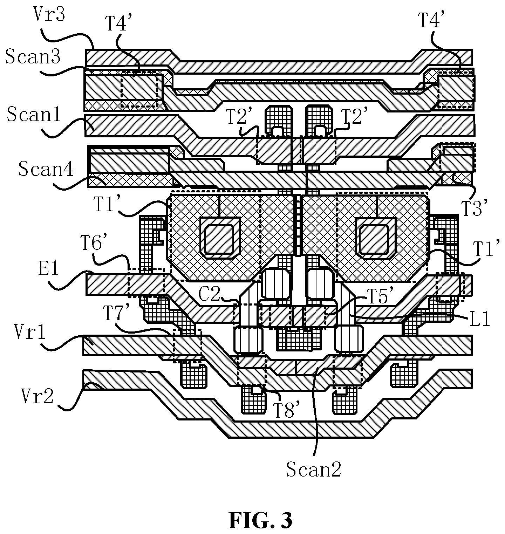

FIG. 3 is a structural view illustrating the layout of a pixel circuit in the related art. As shown in FIG. 3, the source of the first transistor T1' and a drain of the eighth transistor T8' are electrically connected through a connecting portion L1. An overlap exists between the enable line E1 and the connecting portion L1, thereby forming a parasitic capacitor C2. In the light emission stage of the driving process of the pixel circuit, the parasitic capacitor C2 affects the potential of the source of the first transistor T1', affects the voltage difference between the gate and source of the first transistor T1', affects the drive current of the first transistor T1', and affects the luminous effect of the light-emitting diode D1, causing the light-emitting diode D1 to fail to emit light according to the preset brightness. Moreover, one enable line E1 is connected to the fifth transistors T5' and multiple sixth transistors T6' in multiple pixel circuits located in one row so that the signal transmitted on the enable line E1 experiences different voltage drops at different positions, and the potentials at different positions on the enable line E1 may be different, resulting in the difference in the coupling potential of the parasitic capacitor C2 to the first transistor T1' among the pixel circuits at different positions. The magnitudes of the high and low levels of the enable signals on the enable lines E1 connected to the pixel circuits in different rows are related to the distance between the enable line E1 and a driver chip. For example, the greater the distance between the enable line E1 and the driver chip, the smaller the absolute values of the positive high level and negative low level on the enable line E1. As a result, the potentials of the enable lines E1 connected to the pixel circuits in different rows may be different, resulting in the difference in the coupling potential of the parasitic capacitor C2 to the first transistor T1' among the pixel circuits in different rows. Therefore, the magnitudes of the coupling potentials corresponding to the pixel circuits at different positions are different. That is, the degree to which the parasitic capacitor C2 affects the potential of the source of the first transistor T1' varies among the pixel circuits at different positions. As a result, the degree to which the parasitic capacitor C2 affects the drive current varies among the pixel circuits at different positions, and the degree to which the parasitic capacitor C2 affects the brightness of the light-emitting diode D1 varies among the pixel circuits at different positions, leading to worse display uniformity of the display panel. As shown in FIG. 2, when the target display brightness is lower, pulse width modulation (PWM) technology is used for dimming, that is, the brightness of the light-emitting diode D1 is controlled by controlling the light emission duration of the light-emitting diode D1. The greater the number of pulses, the greater the voltage fluctuations on the enable line E1, and the greater the difference in the coupling potential of the parasitic capacitor C2 to the source of the first transistor T1' among the pixel circuits at different positions. That is, the difference in the degree to which the parasitic capacitor C2 affects the drive current among the pixel circuits at different positions is larger, leading to a larger difference in the brightness of the light-emitting diodes D1 at different positions. As a result, the display uniformity of the display panel is affected.

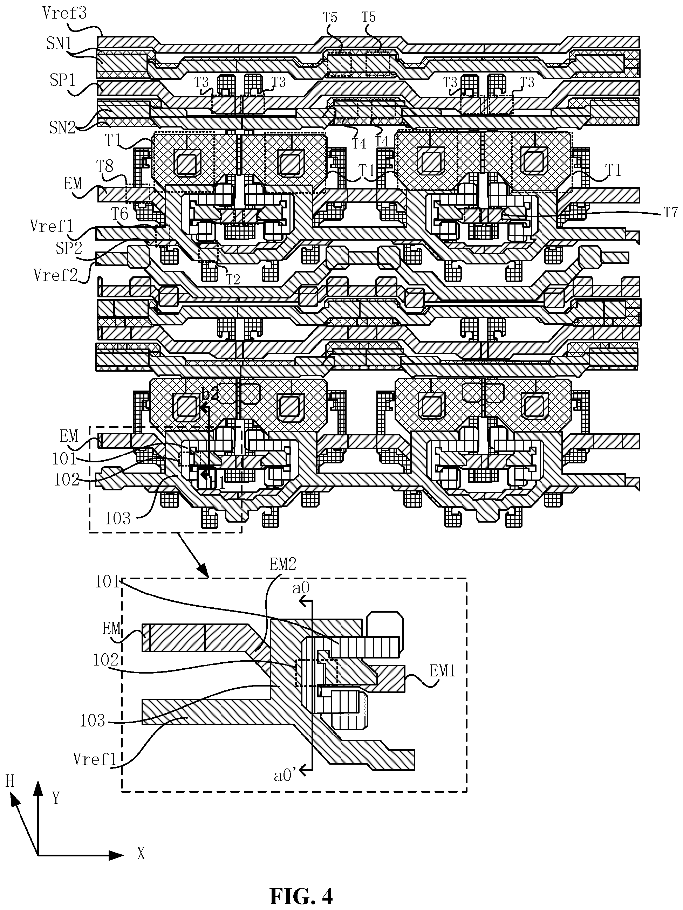

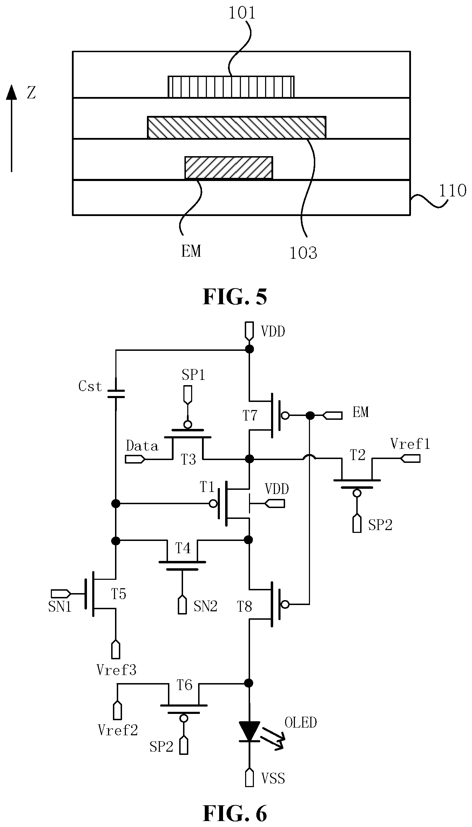

This embodiment provides an array substrate. FIG. 4 is a structural view illustrating the layout of an array substrate according to an embodiment of the present application. FIG. 5 is a sectional view of FIG. 4 taken along a direction a0-a0'. FIG. 6 is a structural diagram of a pixel circuit according to an embodiment of the present application. Referring to FIGS. 4 to 6, the array substrate includes a substrate 110 and a driver circuit layer located on the substrate 110. The driver circuit layer is provided with pixel circuits and a light emission control signal line EM. The pixel circuit includes a drive transistor T1, a first initialization transistor T2, and a first connecting portion 101. The first connecting portion 101 is connected between a first electrode of the drive transistor T1 and the first initialization transistor T2. An overlapping portion 102 exists between the orthographic projection of the first connecting portion 101 on the substrate and the orthographic projection of the light emission control signal line EM on the substrate. Referring to FIG. 4, a shielding portion 103 is further provided in the driver circuit layer, and the orthographic projection of the shielding portion 103 on the substrate 110 overlaps the overlapping portion 102. The film where the shielding portion 103 is located is between the film where the light emission control signal line EM is located and the film where the first connecting portion 101 is located; and/or at least one organic insulating layer is provided between the film where the first connecting portion 101 is located and the film where the light emission control signal line EM is located; and/or the thickness D of the insulating layer between the film where the first connecting portion 101 is located and the film where the light emission control signal line EM is located is greater than 3 micrometers.

The array substrate may include multiple pixel circuits, and each pixel circuit may be connected to a respective OLED in the display panel. The pixel circuit may be formed by components such as thin-film transistors and capacitors. The pixel circuit is configured to provide a drive current for the OLED so that the OLED emits light in response to the drive current. The first electrode of the drive transistor T1 may be the source or drain of the drive transistor T1. Optionally, the film where the light emission control signal line EM is located, the film where the shielding portion 103 is located, and the film where the first connecting portion 101 is located are sequentially stacked along a thickness direction Z of the substrate (for example, along a direction away from the substrate). The shielding portion 103 may include electrically conductive materials such as metal materials and indium tin oxide (ITO).

In some embodiments, the shielding portion 103 is located between the film where the light emission control signal line EM is located and the film where the first connecting portion 101 is located, and the shielding portion 103 is located between the light emission control signal line EM and the first connecting portion 101 so that the shielding portion 103 shields the signal on the light emission control signal line EM, thereby eliminating or reducing the coupling degree (for example, the degree of potential pull-down) of the parasitic capacitor generated at the overlapping portion 102 between the light emission control signal line EM and the first connecting portion 101 to the potential of the first electrode of the drive transistor T1. In this manner, the difference in the coupling degree of the parasitic capacitor to the potential of the first electrode of the drive transistor T1 is reduced among different pixel circuits. Therefore, the degree to which the parasitic capacitor affects the drive current is the same or substantially the same among the pixel circuits at different positions, thereby making the display brightness of different OLEDs tend to be consistent at the same gray level, which is conducive to improving the display uniformity of the display panel and enhancing the display effect of the display panel.

In some embodiments, the film where the first connecting portion 101 is located and the film where the light emission control signal line EM is located are stacked along the thickness direction Z of the substrate. At least one organic insulating layer is provided between the film where the first connecting portion 101 is located and the film where the light emission control signal line EM is located, at least one organic insulating layer is provided between the first connecting portion 101 and the light emission control signal line EM, and the orthographic projection of at least one organic insulating layer on the substrate overlaps the overlapping portion 102 so that the dielectric layer thickness between the first connecting portion 101 and the light emission control signal line EM is larger, and the facing distance between the first connecting portion 101 and the light emission control signal line EM (the distance along the thickness direction Z of the substrate) is larger, thereby reducing the parasitic capacitance at the overlapping portion 102. Moreover, the organic insulating layer can reduce the dielectric constant of the parasitic capacitor, thereby further reducing the parasitic capacitance at the overlapping portion 102.

In some embodiments, after at least one organic insulating layer is provided between the film where the first connecting portion 101 is located and the film where the light emission control signal line EM is located, the shielding portion 103 may be further provided, thereby further reducing the influence of the parasitic capacitor at the overlapping portion 102 on the potential of the first electrode of the drive transistor T1, reducing the influence of the parasitic capacitor on the drive current of the drive transistor T1, and further reducing the influence of the parasitic capacitor on the brightness of the OLED light-emission device, which is conducive to improving the display effect of the display panel.

In some embodiments, the thickness D of the insulating layer between the film where the first connecting portion 101 is located and the film where the light emission control signal line EM is located (the thickness along the thickness direction Z of the substrate 110, where one insulating layer may be provided between the film where the first connecting portion 101 is located and the film where the light emission control signal line EM is located, where D may be the thickness of the insulating layer; or multiple insulating layers may be provided between the film where the first connecting portion 101 is located and the film where the light emission control signal line EM is located, where D may be the sum of the thicknesses of the multiple insulating layers) is greater than 3 micrometers, and the orthographic projection of the insulating layer between the film where the first connecting portion 101 is located and the film where the light emission control signal line EM is located on the substrate overlaps the overlapping portion 102 so that the dielectric layer thickness between the first connecting portion 101 and the light emission control signal line EM is larger, which is greater than 3 micrometers, that is, the facing distance between the first connecting portion 101 and the light emission control signal line EM at the overlapping part is greater than 3 micrometers. The facing distance (the distance along the thickness direction Z of the substrate) between the first connecting portion 101 and the light emission control signal line EM may be larger, thereby reducing the parasitic capacitance at the overlapping portion 102. For example, the parasitic capacitance at the overlapping portion 102 may be less than 0.85 fF, where 1 pF = 1000 fF.

In the technical solution of this embodiment, the shielding portion is provided, the orthographic projection of the shielding portion on the substrate overlaps the overlapping portion, and the film where the shielding portion is located is between the film where the light emission control signal line is located and the film where the first connecting portion is located so that the shielding portion shields the signal transmitted on the light emission control signal line, thereby eliminating or reducing the coupling degree (the degree of potential pull-down) of the parasitic capacitor generated at the overlapping portion between the light emission control signal line and the first connecting portion to the potential of the first electrode of the drive transistor. In this manner, the difference in the coupling degree of the parasitic capacitor to the potential of the first electrode of the drive transistor is reduced among the pixel circuits at different positions. Therefore, the degree to which the parasitic capacitor affects the drive current is the same or substantially the same among the pixel circuits at different positions, thereby making the display brightness of the light-emitting devices at different positions tend to be consistent at the same gray level, which is conducive to improving the display uniformity of the display panel and enhancing the display effect of the display panel. At least one organic insulating layer is provided between the film where the first connecting portion is located and the film where the light emission control signal line is located so that the facing distance between the light emission control signal line and the first connecting portion is increased, and the dielectric constant of the parasitic capacitor at the overlapping portion is reduced, thereby reducing the parasitic capacitance and reducing the influence of the parasitic capacitor on the brightness of the light-emitting device, which is conducive to improving the display effect of the display panel. The thickness of the insulating layer between the film where the first connecting portion is located and the film where the light emission control signal line is located is greater than 3 micrometers so that the facing distance between the light emission control signal line and the first connecting portion is increased, thereby reducing the parasitic capacitance and reducing the influence of the parasitic capacitor on the brightness of the light-emitting device, which is conducive to improving the display effect of the display panel. Based on the preceding technical solution, optionally, the shielding portion 103 is connected to a direct current potential.

If the direct current potential is a signal with a fixed potential, no potential change occurs on the shielding portion 103 as the potential of the light emission control signal line EM changes. Therefore, the amount of the potential change of the first connecting portion 101 affected by the potential change of the light emission control signal line EM is reduced or becomes zero so that the coupling degree of the light emission control signal line EM to the potential of the first electrode of the drive transistor T1 can be reduced, that is, the coupling degree of the changing potential on the light emission control signal line EM to the potential of the first electrode of the drive transistor T1 can be reduced. In this manner, the difference in the coupling degree of the parasitic capacitor to the potential of the first electrode of the drive transistor is reduced among the pixel circuits at different positions. Therefore, the degree to which the parasitic capacitor affects the drive current is the same or substantially the same among the pixel circuits at different positions, thereby making the display brightness of the OLEDs at different positions tend to be consistent at the same gray level, which is conducive to further improving the display uniformity of the display panel. The direct current potential may be provided by the pixel circuit, the scan circuit, or the like on the array substrate. This is, the shielding portion can be electrically connected to the pixel circuit, the scan circuit, or the like on the array substrate and connected to the same direct current potential so that no additional power supply is required. The direct current potential may also be obtained by additionally providing a power supply and a signal line.

Optionally, the driver circuit layer is further provided with a first power supply line and/or an initialization signal line, and the shielding portion 103 is electrically connected to the first power supply line or the initialization signal line.

The first power supply line transmits the first power supply voltage, which may be a high-level voltage or a low-level voltage. Therefore, when the shielding portion 103 is connected to the first power supply line, the signal transmitted on the shielding portion 103 is a direct current signal, that is, a signal with a fixed potential, thereby reducing the coupling degree of the light emission control signal line EM to the potential of the first electrode of the drive transistor T1. An initialization signal is transmitted on the initialization signal line, and the initialization signal is a signal with a fixed potential. Therefore, when the shielding portion 103 is connected to the initialization signal line, the signal transmitted on the shielding portion 103 is a signal with a fixed potential, thereby reducing the coupling degree of the light emission control signal line EM to the potential of the first electrode of the drive transistor T1. A direct current signal line that is connected to the shielding portion 103 can be selected in proximity, such as the first power supply line or the initialization signal line, thereby reducing wiring difficulty.

Based on the preceding technical solutions, the arrangement manner in which at least one organic insulating layer is provided between the film where the first connecting portion 101 is located and the film where the light emission control signal line is located is described below, which is not intended to limit the present application.

Optionally, the driver circuit layer includes a first conductive layer M1, a second conductive layer M2, a third conductive layer M3, a fourth conductive layer M4, and a fifth conductive layer M5 that are stacked. Optionally, the light emission control signal line EM is disposed in the first conductive layer M1.

Optionally, the first conductive layer M1, the second conductive layer M2, the third conductive layer M3, the fourth conductive layer M4, and the fifth conductive layer M5 are sequentially stacked along a direction away from the substrate. Optionally, the first conductive layer M1, the second conductive layer M2, the third conductive layer M3, the fourth conductive layer M4, and the fifth conductive layer M5 may each include one or more of a metal layer, an ITO layer, or the like.

Optionally, the first connecting portion 101 is disposed in the fourth conductive layer M4 or on a side of the fourth conductive layer M4 facing away from the substrate 110. Optionally, when the shielding portion 103 is provided in the driver circuit layer, the first connecting portion 101 is disposed in the fourth conductive layer M4 or on a side of the fourth conductive layer M4 facing away from the substrate 110. Optionally, when at least one organic insulating layer is provided between the film where the first connecting portion 101 is located and the film where the light emission control signal line is located, the first connecting portion 101 is disposed on a side of the fourth conductive layer M4 facing away from the substrate 110.

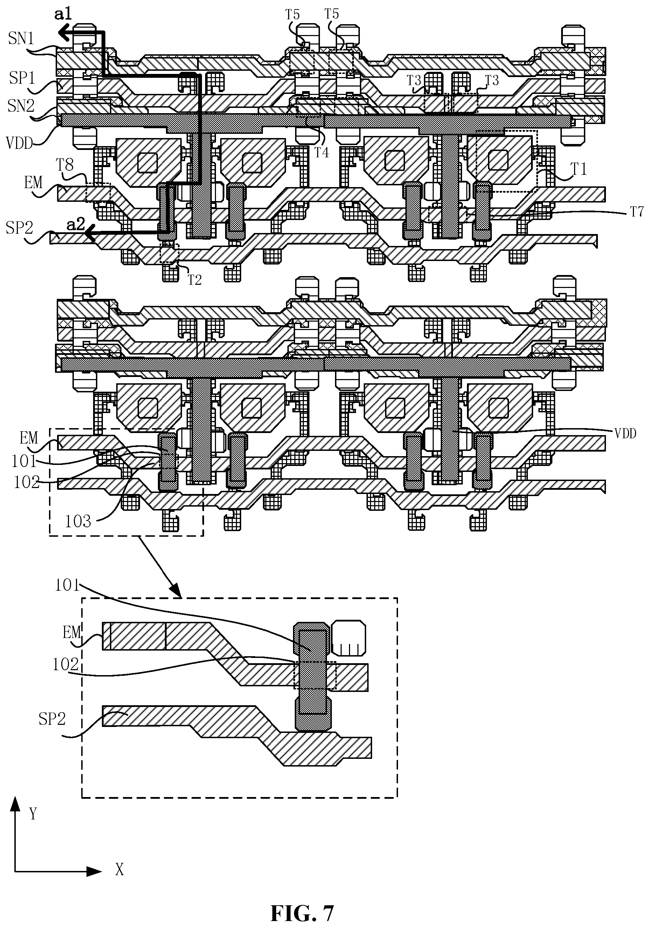

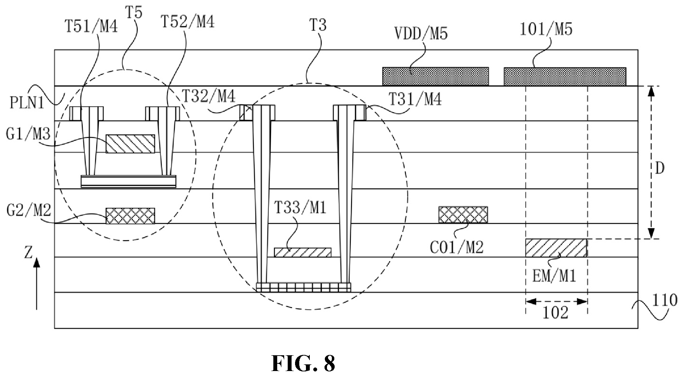

In some embodiments, FIG. 7 is a structural view illustrating the layout of another array substrate according to an embodiment of the present application, and FIG. 8 is a sectional view of FIG. 7 taken along a direction a1-a2. Optionally, referring to FIGS. 7 and 8, the first connecting portion 101 is disposed on a side of the fourth conductive layer M4 facing away from the substrate 110. In this manner, the facing distance between the first connecting portion 101 and the light emission control signal line EM is larger, which is conducive to reducing the parasitic capacitance at the overlapping portion 102 between the first connecting portion 101 and the light emission control signal line EM. Moreover, the first connecting portion 101 is disposed on a side of the fourth conductive layer M4 facing away from the substrate 110, thereby facilitating the arrangement of the organic insulating layer. The organic insulating layer may be disposed between two of the second conductive layer M2, the third conductive layer M3, the fourth conductive layer M4, and the fifth conductive layer M5. The organic insulating layers may be provided between the second conductive layer M2 and the third conductive layer M3, between the third conductive layer M3 and the fourth conductive layer M4, and between the fourth conductive layer M4 and the fifth conductive layer M5, respectively, thereby greatly reducing the parasitic capacitance at the overlapping portion 102, which is conducive to reducing the influence of the parasitic capacitor corresponding to the overlapping portion 102 on the display effect of the display panel.

FIGS. 7 and 8 illustrate the case where the first connecting portion 101 is located in the fifth conductive layer M5, which is not limited thereto. FIG. 8 illustrates the case where an organic insulating layer (a first organic planarization layer PLN1, for example, located between the fourth conductive layer M4 and the fifth conductive layer M5) is provided, which is not limited thereto.

Optionally, the pixel circuit further includes a data write transistor T3. As shown in FIG. 8, a first electrode T31 and a second electrode T32 of the data write transistor T3 are disposed in the fourth conductive layer M4, and a gate T33 of the data write transistor T3 is disposed in the first conductive layer M1. The first electrode T31 of the data write transistor T3 is the source of the data write transistor T3, and the second electrode T32 of the data write transistor T3 is the drain of the data write transistor T3. Alternatively, the first electrode T31 of the data write transistor T3 is the drain of the data write transistor T3, and the second electrode T32 of the data write transistor T3 is the source of the data write transistor T3.

Optionally, referring to FIGS. 6 and 8, the pixel circuit includes a storage capacitor Cst, and a first electrode plate C01 of the storage capacitor Cst is disposed in the second conductive layer M2.

Optionally, the pixel circuit further includes a switching transistor connected to a gate of the drive transistor T1, a first gate G1 of the switching transistor is disposed in the third conductive layer M3, and the fifth conductive layer M5 is provided with a first power supply line VDD configured to provide a first power supply voltage for the pixel circuit.

If the switching transistor is an N-type transistor, the leakage current of the switching transistor is smaller so that the potential change of the gate of the drive transistor T1 is smaller, which is conducive to maintaining the potential of the gate of the drive transistor T1. In this case, the drive current generated by the drive transistor T1 is more stable so that the brightness of the OLED is more stable. The first gate of the switching transistor is, for example, the top gate, and the first gate of the switching transistor is disposed in the third conductive layer M3. The third conductive layer M3 may be made of a cesium tungsten oxide (GATO) nanomaterial.

For example, referring to FIG. 6, the switching transistor includes a threshold compensation transistor T4 and/or a third initialization transistor T5, the threshold compensation transistor T4 and the third initialization transistor T5 are connected to the gate of the drive transistor T1, and the threshold compensation transistor T4 and the third initialization transistor T5 may be N-type transistors.

Optionally, referring to FIG. 6, the first terminal of the OLED is connected to the pixel circuit, and the second terminal of the OLED is connected to a second power supply line VSS. The first terminal of the OLED is the anode, and the second terminal of the OLED is the cathode; or the first terminal of the OLED is the cathode, and the second terminal of the OLED is the anode.

Optionally, as shown in FIG. 8, a first electrode T51 and a second electrode T52 of the third initialization transistor T5 are located in the fourth conductive layer M4, and a first gate G1 (top gate) of the third initialization transistor T5 is located in the third conductive layer M3. The third initialization transistor T5 may be configured with a single-gate structure or a dual-gate structure. Optionally, a second gate G2 (bottom gate) of the third initialization transistor T5 is located in the second conductive layer M2. The first gate G1 and the second gate G2 of the third initialization transistor T5 are connected together and receive the same signal, or the first gate G1 and the second gate G2 of the third initialization transistor T5 are insulated from each other and receive different signals. The first electrode T51 of the third initialization transistor T5 is the source of the third initialization transistor T5, and the second electrode T52 of the third initialization transistor T5 is the drain of the third initialization transistor T5; or the first electrode T51 of the third initialization transistor T5 is the drain of the third initialization transistor T5, and the second electrode T52 of the third initialization transistor T5 is the source of the third initialization transistor T5. An active portion of the third initialization transistor T5 is located between the first gate G1 and the second gate G2 of the third initialization transistor T5.

In some embodiments, optionally, as shown in FIGS. 7 and 8, the first connecting portion 101 is disposed in the fifth conductive layer M5. The organic insulating layer is disposed between the fourth conductive layer M4 and the fifth conductive layer M5. Optionally, an inorganic insulating layer is disposed between any two adjacent ones of the first conductive layer M1, the second conductive layer M2, the third conductive layer M3, and the fourth conductive layer M4. In this manner, the facing distance between the first connecting portion 101 and the light emission control signal line EM can be further increased, which is conducive to further reducing the parasitic capacitance at the overlapping portion 102 between the first connecting portion 101 and the light emission control signal line EM.

Based on the preceding technical solutions, optionally, referring to FIG. 4, the overlapping portion 102 is located within the orthographic projection of the shielding portion 103 on the substrate 110. In this manner, it can be ensured that the orthographic projection of the shielding portion 103 on the substrate 110 completely covers the overlapping portion 102, thereby achieving a better shielding effect. Moreover, the orthographic projection of the shielding portion 103 on the substrate 110 can cover the portion where the orthographic projection of the first connecting portion 101 on the substrate 110 and the orthographic projection of the light emission control signal line EM on the substrate 110 do not overlap so that part of the lateral capacitance between the first connecting portion 101 and the light emission control signal line EM can be shielded, which is conducive to better shielding the parasitic capacitance and further reducing the influence of the parasitic capacitor on the potential of the first electrode of the drive transistor T1.

As an implementation of this embodiment, based on the preceding embodiments, the setting of the shielding portion is described below, which is not intended to limit the present application.

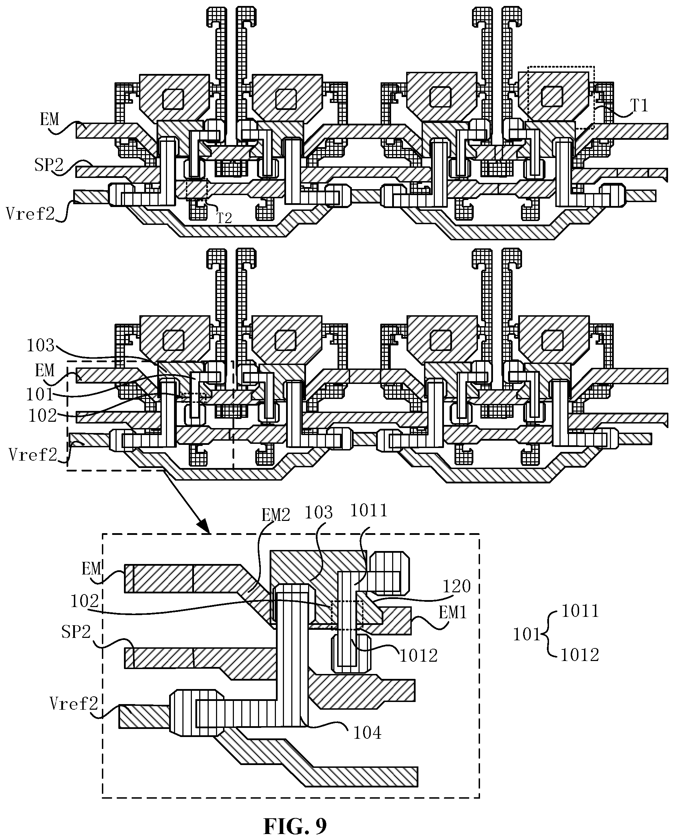

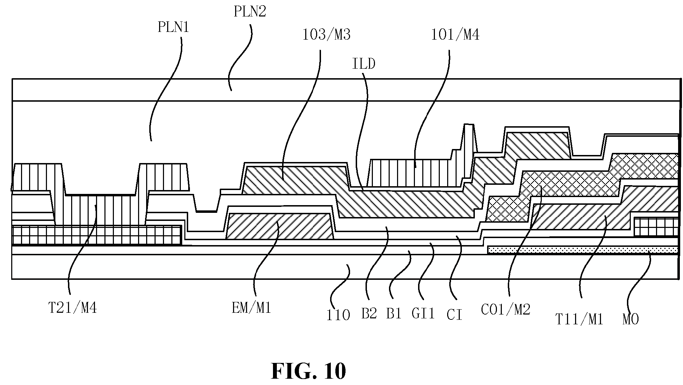

In some embodiments, FIG. 9 is a structural view illustrating the layout of another array substrate according to an embodiment of the present application, and FIG. 10 is a sectional view of FIG. 4 taken along a direction b1-b2. Optionally, referring to FIGS. 6, 9, and 10, the pixel circuit further includes a second initialization transistor T6, the driver circuit layer is further provided with a first initialization signal line Vref1 and a second initialization signal line Vref2, the first initialization transistor T2 is connected between the first initialization signal line Vref1 and the first electrode of the drive transistor T1, the second initialization transistor T6 is connected between the second initialization signal line Vref2 and the first terminal of the OLED, and the shielding portion 103 is electrically connected to the first initialization signal line Vref1 or the second initialization signal line Vref2.

FIGS. 4 and 10 illustrate the connection between the shielding portion 103 and the first initialization signal line Vref1. The shielding portion 103 and the first initialization signal line Vref1 (extending along a first direction X) may be disposed in the same layer. Optionally, the shielding portion 103 is disposed in the third conductive layer M3. FIG. 9 illustrates the connection between the shielding portion 103 and the second initialization signal line Vref2. As shown in FIG. 9, the shielding portion 103 is connected to the second initialization signal line Vref2 through a via and a second connecting portion in a conductive layer (for example, the fourth conductive layer) located on a side of the shielding portion 103 facing away from the substrate. The shielding portion 103 and the second initialization signal line Vref2 (extending along the first direction) may be disposed in the same layer. Optionally, the shielding portion 103 is disposed in the third conductive layer M3. Multiple structures disposed in the same layer can be obtained by patterning the same film, thereby simplifying the process. Multiple structures disposed in the same layer can be made of the same material and can be prepared simultaneously using the same process. The shielding portions 103 of the pixel circuits at different positions may be connected to different signal lines or the same signal line.

The preceding initialization signal lines include the first initialization signal line Vref1 and the second initialization signal line Vref2. The signals transmitted on the first initialization signal line Vref1 and the second initialization signal line Vref2 are direct current signals, that is, signals with fixed potentials. Therefore, the shielding portion 103 is electrically connected to the first initialization signal line Vref1 and/or the second initialization signal line Vref2 so that the potential on the shielding portion 103 can remain unchanged, thereby reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, thereby making the brightness of different OLEDs tend to be consistent at the same gray level, which is conducive to improving the display uniformity of the display panel. The shielding portion 103 is adjacent to the first initialization signal line Vref1 and/or the second initialization signal line Vref2, thereby facilitating wiring connection.

Optionally, the gate of the first initialization transistor T2 and the gate of the second initialization transistor T6 are electrically connected to the same scan signal line. In this manner, the first initialization transistor T2 and the second initialization transistor T6 can be turned on simultaneously so that the first electrode of the drive transistor T1 and the OLED can be simultaneously initialized, thereby facilitating control; moreover, the number of scan signal lines is reduced, thereby facilitating the wiring design.

Optionally, the driver circuit layer further includes the third conductive layer M3; the pixel circuit further includes the switching transistor; the switching transistor is connected to the gate of the drive transistor T1; and the third conductive layer M3 is provided with the first gate of the switching transistor.

Optionally, the first initialization signal line Vref1 and/or the second initialization signal line Vref2 are disposed in the third conductive layer M3. In this manner, when the first connecting portion 101 is disposed in the fourth conductive layer M4 or disposed on a side of the fourth conductive layer M4 facing away from the substrate 110 (for example, disposed in the fifth conductive layer M5), the shielding portion 103 can shield the first connecting portion 101 from the light emission control signal line EM, thereby reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, which is conducive to reducing the influence of the parasitic capacitor on the display effect of the display panel.

Optionally, as shown in FIG. 10, a gate T11 of the drive transistor T1 and the light emission control signal line EM are disposed in the first conductive layer M1, the first electrode plate C01 of the storage capacitor Cst is disposed in the second conductive layer M2, the shielding portion 103 is disposed in the third conductive layer M3, and the first connecting portion 101 and a first electrode T21 of the first initialization transistor T2 (the electrode connected to the first electrode of the drive transistor T1) are disposed in the fourth conductive layer M4. In this manner, the connection between the shielding portion 103 and the first initialization signal line Vref1 located in the third conductive layer M3 can be facilitated so that the shielding portion 103 can receive the direct current signal and thus can more effectively shield the first connecting portion 101 and the light emission control signal line EM.

Optionally, as shown in FIG. 10, the driver circuit layer further includes a first buffer layer B1, a first gate insulating layer GI1, a capacitor insulating layer CI, a second buffer layer B2, a second gate insulating layer, a first organic planarization layer PLN1, and a second organic planarization layer PLN2. The first buffer layer B1 is located between the substrate 110 and the first conductive layer M1. The first buffer layer B1 has an isolation function, which can prevent damage to the substrate 110 during subsequent film etching, and the first buffer layer B1 can improve the adhesion of the first conductive layer M1. The first gate insulating layer GI1 is located between the first buffer layer B1 and the first conductive layer M1 and is used for isolating a gate (for example, a first electrode T11 of the drive transistor T1) in the first conductive layer M1. The capacitor insulating layer CI is located between the first conductive layer M1 and the second conductive layer M2 and is used for isolating the first electrode plate C01 of the storage capacitor Cst in the second conductive layer M2, thereby preventing the signal on the first conductive layer M1 from interfering with the potential on the first electrode plate C01. The second buffer layer B2 is located between the second conductive layer M2 and the third conductive layer M3. The second buffer layer B2 has the functions of buffering, protection, and insulation. The second gate insulating layer is located between the third conductive layer M3 and a first active layer, an interlayer insulating layer ILD is located between the third conductive layer M3 and the fourth conductive layer M4, and the second gate insulating layer is used for isolating a gate (for example, the top gate of the preceding switching transistor) in the third conductive layer M3 to achieve the effect of insulation. The first organic planarization layer PLN1 is located on a side of the third conductive layer M3 facing away from the substrate 110, and the second organic planarization layer PLN2 is located on a side of the first organic planarization layer PLN1 facing away from the substrate 110.

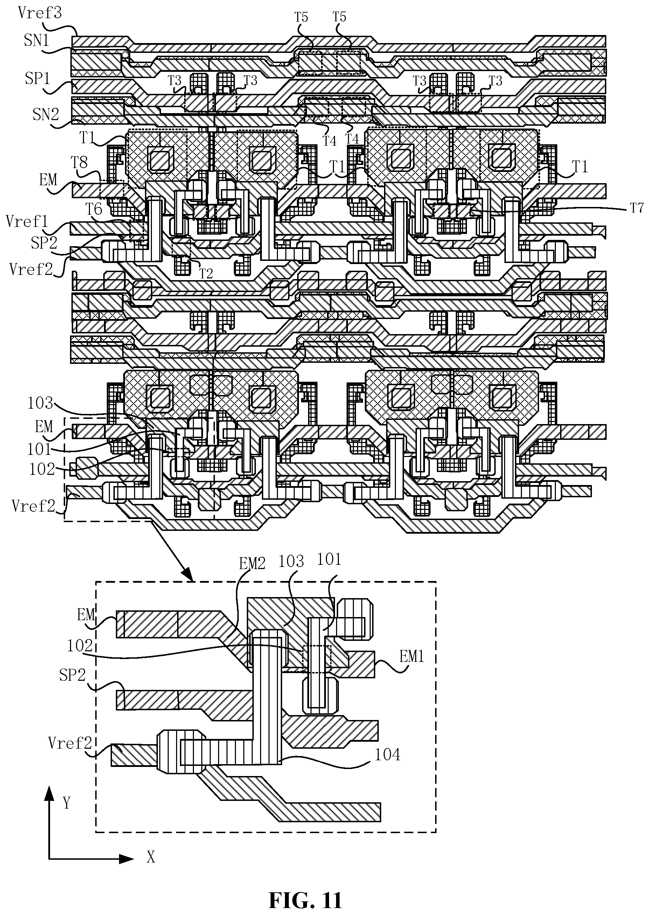

FIG. 11 is a structural view illustrating the layout of another array substrate according to an embodiment of the present application. Optionally, as shown in FIG. 11, the orthographic projection of the first initialization signal line Vref1 on the substrate 110 is located between the orthographic projection of the second initialization signal line Vref2 on the substrate 110 and the orthographic projection of the shielding portion 103 on the substrate 110; and the orthographic projection of the first initialization signal line Vref1 on the substrate 110 is located between the orthographic projection of the second initialization signal line Vref2 on the substrate 110 and the orthographic projection of the light emission control signal line EM on the substrate 110.

Optionally, as shown in FIG. 11, the extension direction (which may be the extension trend or the general extension direction) of the first initialization signal line Vref1, the second initialization signal line Vref2, and the light emission control signal line EM is the first direction X, and the first initialization signal line Vref1, the second initialization signal line Vref2, and the light emission control signal line EM are arranged along a second direction Y, where the first direction X and the second direction Y intersect. That is, the first initialization signal line Vref1 does not overlap the light emission control signal line EM, and the second initialization signal line Vref2 does not overlap the light emission control signal line EM.

Optionally, as shown in FIGS. 9 and 11, the second initialization signal line Vref2 is electrically connected to the shielding portion 103 through a second connecting portion 104, and the second connecting portion 104 and the first initialization signal line Vref1 intersect and are insulated from each other. Optionally, as shown in FIG. 11, the film where the second connecting portion 104 is located is on a side of the film where the first initialization signal line Vref1 is located facing away from the substrate 110. Optionally, as shown in FIG. 11, the first connecting portion 101 and the second connecting portion 104 are disposed in the same layer. In this manner, the electrical connection between the second initialization signal line Vref2 and the shielding portion 103 can be facilitated, and the first initialization signal line Vref1 is not connected to the second initialization signal line Vref2 so that the first initialization signal line Vref1 and the second initialization signal line Vref2 can provide different initialization signals as required.

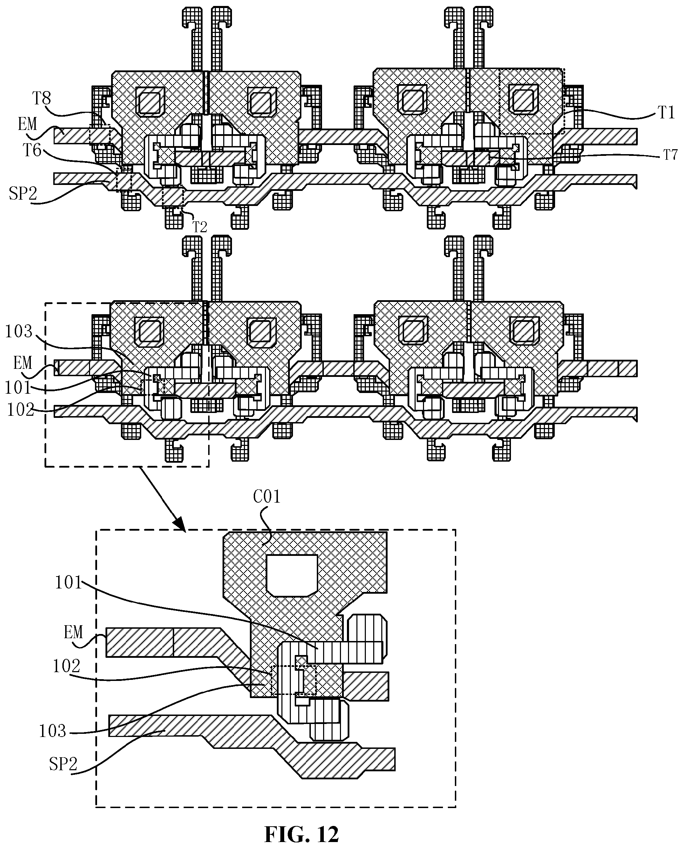

In some embodiments, FIG. 12 is a structural view illustrating the layout of another array substrate according to an embodiment of the present application. Optionally, referring to FIGS. 6 and 12, the pixel circuit further includes the storage capacitor Cst, the first electrode plate C01 of the storage capacitor Cst is connected to the first power supply line VDD, and the first electrode plate C01 and the shielding portion 103 are electrically connected to form an integral structure and are disposed in the same layer.

The first electrode plate C01 of the storage capacitor Cst is connected to a direct current signal so that the shielding portion 103 is connected to a direct current signal, that is, a signal with a fixed potential. Therefore, the potential on the shielding portion 103 can remain unchanged, thereby reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, thereby making the brightness of different OLEDs tend to be consistent at the same gray level, which is conducive to improving the display uniformity of the display panel.

Optionally, referring to FIG. 12, the driver circuit layer further includes the second conductive layer M2, where the second conductive layer M2 is provided with the first electrode plate C01 of the storage capacitor Cst. Optionally, the second electrode plate of the storage capacitor Cst is reused as the gate of the drive transistor T1. In this manner, when the first connecting portion 101 is disposed in the fourth conductive layer M4 or disposed on a side of the fourth conductive layer M4 facing away from the substrate 110 (for example, disposed in the fifth conductive layer M5), the shielding portion 103 can shield the first connecting portion 101 from the light emission control signal line EM, thereby reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, which is conducive to reducing the influence of the parasitic capacitor on the display effect of the display panel.

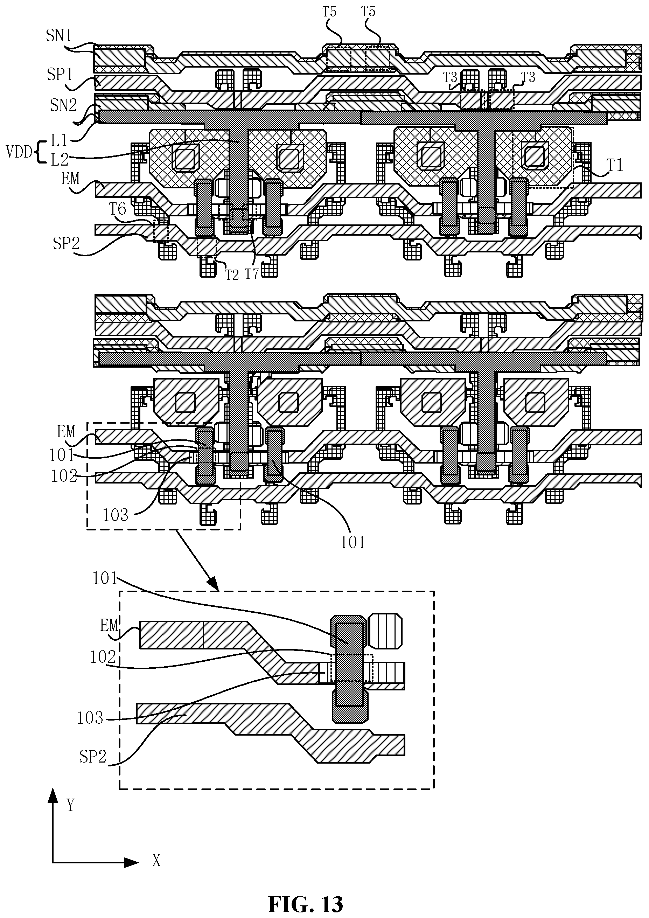

In some embodiments, FIG. 13 is a structural view illustrating the layout of another array substrate according to an embodiment of the present application. Optionally, referring to FIG. 13, the driver circuit layer is provided with the first power supply line VDD, the first power supply line VDD includes a first sub-line L1 and a second sub-line L2 electrically connected, the pixel circuit further includes a first light emission control transistor T7, the first light emission control transistor T7 is electrically connected to the second sub-line L2, and the second sub-line L2 is electrically connected to the shielding portion 103. Optionally, the shielding portion 103 extends along the first direction, the first sub-line L1 extends along the first direction X, the extension direction of the second sub-line L2 intersects with the first direction X, and the first sub-line L1 and the second sub-line L2 are disposed in the same layer. Optionally, the first light emission control transistor T7 is connected between the first electrode of the drive transistor T1 and the second sub-line L2, and a gate of the first light emission control transistor T7 is electrically connected to the light emission control signal line EM. In this manner, the shielding portion 103 can be connected to a direct current potential, which is conducive to reducing the coupling degree of the parasitic capacitor to the potential of the first electrode of the first transistor T1.

Optionally, the driver circuit layer further includes the fourth conductive layer M4 and the fifth conductive layer M5, the first connecting portion 101 is disposed in the fifth conductive layer M5, and the shielding portion 103 is disposed in the fourth conductive layer M4. In this manner, the film where the shielding portion 103 is located is between the film where the first connecting portion 101 is located and the film where the light emission control signal line EM is located so that the signal transmitted on the light emission control signal line EM can be shielded, thereby reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, which is conducive to reducing the influence of the parasitic capacitor on the display effect of the display panel.

The first direction X may be the row direction of the array substrate, that is, the row direction of the pixel circuit array arrangement. The first sub-line L1 may be electrically connected to the first electrode plate C01 of the storage capacitor Cst.

Optionally, as shown in FIG. 13, the first sub-line L1 and the second sub-line L2 are disposed in the fifth conductive layer M5, and the second sub-line L2 is electrically connected to the shielding portion 103 through a via.

The second sub-line L2 of the first power supply line VDD is electrically connected to the shielding portion 103 so that the shielding portion 103 is connected to a direct current signal. Therefore, the sudden change in the potential on the shielding portion 103 can be prevented, which is conducive to reducing the coupling degree of the light emission control signal line EM to the potential of the first electrode of the drive transistor T1. In this manner, the difference in the coupling degree of the parasitic capacitor to the potential of the first electrode of the drive transistor is reduced among the pixel circuits at different positions, thereby making the brightness of different OLEDs tend to be consistent at the same gray level, which is conducive to further improving the display uniformity of the display panel.

Optionally, as shown in FIG. 13, among three adjacent pixel circuits along the first direction X, the shielding portion 103 in the pixel circuit located in the middle is connected to the shielding portion 103 in the pixel circuit located on one side, and the distance between the first connecting portion 101 in the pixel circuit located in the middle and the first connecting portion 101 in the pixel circuit located on one side (which may be the distance along the first direction X) is less than the distance between the first connecting portion 101 in the pixel circuit located in the middle and the first connecting portion 101 in the pixel circuit located on the other side (which may be the distance along the first direction X). In other words, the shielding portions 103 in two adjacent pixel circuits in the first direction X are connected, and the first connecting portions 101 in the two adjacent pixel circuits are adjacent to each other. That is, one shielding portion 103 corresponds to two adjacent pixel circuits in the first direction. The first direction X may be the row direction. The second direction Y may be the column direction. FIG. 13 illustrates the pixel circuits in two rows and four columns, where among the four pixel circuits in the same row, the distance between the first connecting portions 101 in the two left pixel circuits is less than the distance between the first connecting portions 101 in the two pixel circuits located in the middle. Optionally, two adjacent pixel circuits along the first direction are arranged in a mirror-symmetrical manner. In this manner, the number of shielding portions 103 can be reduced, and it is unnecessary to prepare one shielding portion 103 for each pixel circuit, making wiring simple and convenient.

Optionally, as shown in FIGS. 4, 9, and 13, one shielding portion 103 corresponds to one pixel circuit. Each of the multiple pixel circuits is provided with the shielding portion 103, and the shielding portions 103 in two adjacent pixel circuits are spaced apart.

Based on the preceding technical solutions, the parasitic capacitor corresponding to the overlapping portion 102 between the orthographic projection of the first connecting portion 101 on the substrate and the orthographic projection of the light emission control signal line EM on the substrate is the orthogonal capacitor, and the lateral capacitance may be generated at the portion where the first connecting portion 101 and the light emission control signal line EM do not overlap. To further reduce the influence of the parasitic capacitor on the potential of the first electrode of the drive transistor T1, the strategy for reducing the lateral capacitance is described below, which is not intended to limit the present application.

Optionally, referring to FIG. 4, the light emission control signal line EM includes a body portion EM1 extending along the first direction X and an extension portion EM2 extending along a third direction H, where the first direction X intersects with the third direction H; and the orthographic projection of the shielding portion 103 on the substrate 110 at least partially covers the orthographic projection of the extension portion EM2 on the substrate 110.

If the third direction H is oblique relative to the first direction X, then an included angle is formed between the body portion EM1 and the extension portion EM2. If the first connecting portion 101 is adjacent to the included angle, the lateral capacitance is easily generated at the included angle. The orthographic projection of the shielding portion 103 on the substrate 110 at least partially covers the orthographic projection of the extension portion EM2 on the substrate 110 so that it can be ensured that the shielding portion 103 covers the included angle between the body portion EM1 and the extension portion EM2. In this manner, the shielding portion 103 can shield the signal on the light emission control signal line EM, thereby reducing the lateral capacitance at the included angle, which is conducive to further reducing the influence of the parasitic capacitor on the potential of the first connecting portion 101. Therefore, the influence of the parasitic capacitor on the potential of the first electrode of the drive transistor T1 can be reduced, the influence of the parasitic capacitor on the drive current generated by the drive transistor T1 can be reduced, and the influence of the parasitic capacitor on the brightness of the OLED can be reduced, which is conducive to further improving the display effect of the display panel.

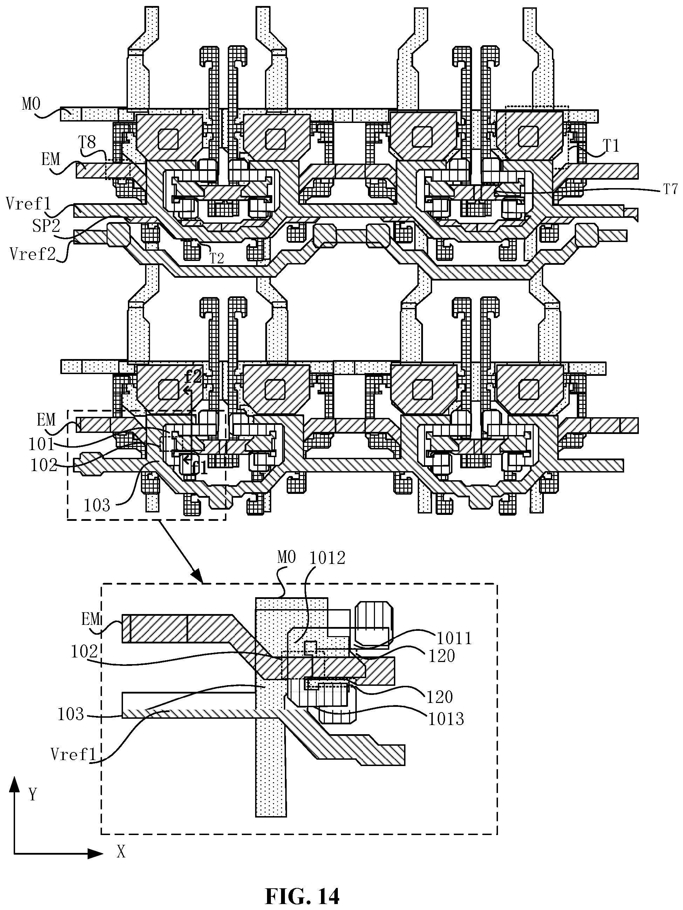

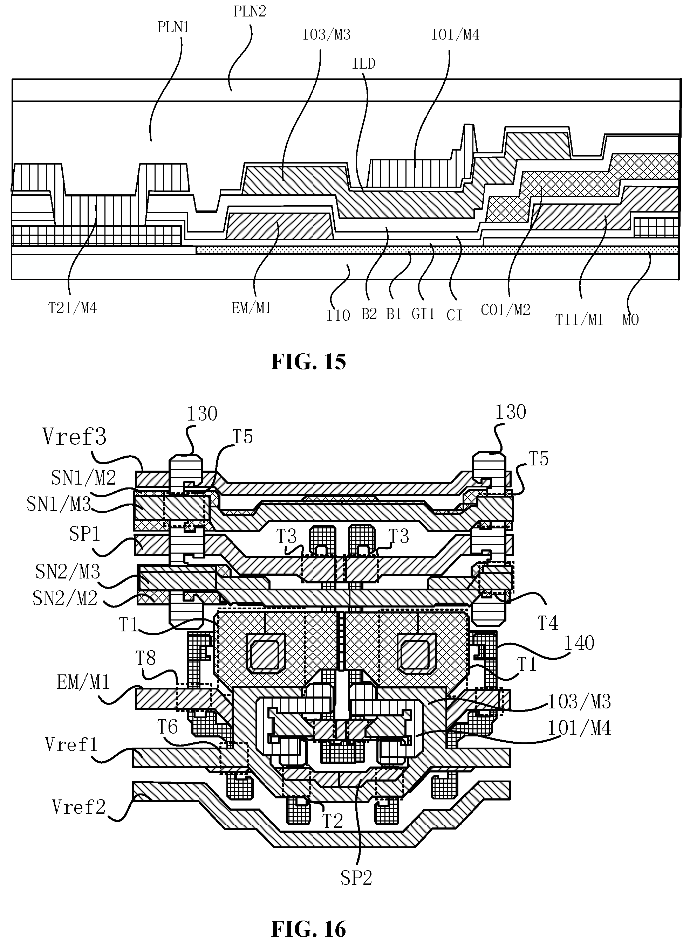

FIG. 14 is a structural view illustrating the layout of another array substrate according to an embodiment of the present application. FIG. 15 is a sectional view of FIG. 14 taken along a direction f1-f2. Optionally, referring to FIGS. 14 and 15, the array substrate further includes a shielding layer M0 located between the substrate 110 and the driver circuit layer; a gap 120 exists between the orthographic projection of the first connecting portion 101 on the substrate 110 and the orthographic projection of the light emission control signal line EM on the substrate 110; and the orthographic projection of the shielding layer M0 on the substrate 110 at least partially overlaps the gap 120.

The first connecting portion 101 and the light emission control signal line EM are coupled at the gap 120 to generate the lateral capacitance. The orthographic projection of the shielding layer M0 on the substrate 110 at least partially overlaps the gap 120. Although the shielding layer M0 is not located between the film where the first connecting portion 101 is located and the film where the light emission control signal line EM is located, the electric field lines formed by the lateral capacitance extend in multiple directions. Therefore, the shielding layer M0 can shield some electric field lines, thereby reducing the lateral capacitance, which is conducive to further reducing the parasitic capacitance generated by the coupling between the light emission control signal line EM and the first connecting portion 101 and thus reducing the influence of the parasitic capacitor on the potential of the first electrode of the drive transistor T1.

Optionally, at least part of the shielding layer M0 is connected to a direct current potential.

Optionally, the shielding layer M0 is electrically connected to the first power supply line VDD. Therefore, when the shielding layer M0 is connected to a direct current signal, the potential on the shielding layer M0 does not fluctuate so that the shielding layer M0 can provide a better shielding effect, which is conducive to reducing the lateral capacitance between the first connecting portion 101 and the light emission control signal line EM. Moreover, by applying a stable voltage to the shielding layer M0, electrostatic shielding can be achieved. The shielding layer M0 may include a metal layer or the like.

Optionally, the orthographic projection of the shielding layer M0 on the substrate 110 at least partially overlaps an active portion of a channel region of the drive transistor T1. In this manner, the shielding layer M0 can provide electrostatic shielding for the drive transistor T1, thereby preventing electrostatic charges from affecting the characteristics of the drive transistor T1, avoiding changes in the threshold voltage of the drive transistor T1, and thus ensuring the stability of the drive current of the drive transistor T1. Moreover, damage to the gate of the drive transistor T1 caused by electrostatic charges can be avoided, thereby protecting the drive transistor T1.

Optionally, the shielding layer M0 is an electrostatic shielding layer and/or a light-shielding layer.

When the shielding layer M0 is an electrostatic shielding layer, electrostatic charges can be prevented from affecting the characteristics of the drive transistor T1 and affecting the display effect of the display panel. When the shielding layer M0 is a light-shielding layer, the influence of ambient light on the characteristics of the drive transistor T1 can be reduced, thereby ensuring the stability of the drive current of the drive transistor T1, which is conducive to improving the display effect of the display panel.

Based on the preceding technical solutions, optionally, referring to FIG. 4, the driver circuit layer is further provided with the first initialization signal line Vref1; the first initialization transistor T2 is connected between the first initialization signal line Vref1 and the first electrode of the drive transistor T1, the extension direction (or extension trend) of the first initialization signal line Vref1 and the light emission control signal line EM is the first direction X, and the first initialization signal line Vref1 and the light emission control signal line EM are arranged along the second direction Y; and the orthographic projection of the first initialization signal line Vref1 on the substrate 110 and the orthographic projection of the light emission control signal line EM on the substrate 110 are separated, that is, the orthographic projections do not overlap. In other words, the original position of the first initialization signal line Vref1 remains unchanged, and the first initialization signal line Vref1 is not moved to serve as the shielding portion 103. When the shielding portion 103 is connected to the first initialization signal line Vref1, the shielding portion 103 and the first initialization signal line Vref1 may be a whole or separate structures connected together, which is not limited thereto.

Optionally, referring to FIG. 4, the shielding portion 103 and the first initialization signal line Vref1 are electrically connected to form an integral structure and are disposed in the same layer; and the shielding portion 103 is connected to one side of the two opposite sides of the first initialization signal line Vref1 along the second direction Y, where the first direction X intersects with the second direction Y, for example, the first direction X is perpendicular to the second direction Y. In other words, the shielding portion 103 may be a portion of the first initialization signal line Vref1 that extends toward one of the two opposite sides along the second direction Y, that is, a portion that extends toward the overlapping portion 102 so that it is ensured that the orthographic projection of the shielding portion 103 on the substrate 110 overlaps the overlapping portion 102, thereby achieving a better shielding effect and effectively reducing the influence of the parasitic capacitor corresponding to the overlapping portion 102 on the potential of the first electrode of the drive transistor T1.

Optionally, FIG. 16 is a structural view illustrating the layout of another array substrate according to an embodiment of the present application. Referring to FIG. 16, the driver circuit layer further includes a first active layer 130, a third conductive layer M3, a second active layer 140, and a first conductive layer M1. An active portion of the drive transistor T1 is located in the second active layer 140, the gate of the drive transistor T1 is located in the first conductive layer M1, and the first initialization signal line Vref1 is located in the third conductive layer M3 or on a side of the third conductive layer M3 facing away from the substrate 110.

Optionally, the second active layer 140, the first conductive layer M1, the first active layer 130, and the third conductive layer M3 are sequentially stacked along a direction away from the substrate 110.

Optionally, the pixel circuit further includes a threshold compensation transistor T4 connected between the gate and the second electrode of the drive transistor T1, an active portion of the threshold compensation transistor T4 is located in the first active layer 130, and a gate of the threshold compensation transistor T4 is located in the third conductive layer M3; and/or the pixel circuit further includes a third initialization transistor T5 electrically connected to the gate of the drive transistor T1, an active portion of the third initialization transistor T5 is located in the first active layer 130, and a gate of the third initialization transistor T5 is located in the third conductive layer M3. Optionally, the second active layer 140 includes polysilicon, and the first active layer 130 includes metal oxide.

The second active layer 140 includes polysilicon, such as Psi, and the drive transistor T1 may be a P-type transistor. In this case, the active portion of the drive transistor T1 is located in the second active layer 140. The gate of the drive transistor T1 is located in the first conductive layer M1, thereby facilitating overlapping with the active portion located in the second active layer 140. The threshold compensation transistor T4 and the third initialization transistor T5 may be N-type transistors. The gates of the threshold compensation transistor T4 and the third initialization transistor T5 are located in the third conductive layer M3, thereby facilitating overlapping with the active portion located in the first active layer 130.

Optionally, the shielding layer M0, the first buffer layer B1, the second active layer 140, the first gate insulating layer GI1, the first conductive layer M1, the capacitor insulating layer CI, the second conductive layer M2, the second buffer layer B2, the first active layer 130, a second gate insulating layer GI2, the third conductive layer M3, the interlayer insulating layer ILD, the fourth conductive layer M4, the first organic planarization layer PLN1, the fifth conductive layer M5, the second organic planarization layer PLN2, and a sixth conductive layer M6 are sequentially stacked along a direction away from the substrate 110.

Optionally, the pixel circuit further includes the first light emission control transistor T7 connected between the first electrode of the drive transistor T1 and the first power supply line VDD, and the gate of the first light emission control transistor T7 is electrically connected to the light emission control signal line EM; and/or the pixel circuit further includes a second light emission control transistor T8 connected between the second electrode of the drive transistor T1 and the first terminal of the OLED, and a gate of the second light emission control transistor T8 is electrically connected to the light emission control signal line EM; and/or the pixel circuit further includes the data write transistor T3 connected between the data line Data and the first electrode of the drive transistor T1; and/or the pixel circuit further includes the storage capacitor Cst connected between the first power supply line VDD and the gate of the drive transistor T1.

Optionally, referring to FIGS. 4 and 6, the driver circuit layer further includes a first scan signal line SP1 electrically connected to a gate of the data write transistor T3. The first scan signal line SP1 is configured to control the data write transistor T3 to be turned on in the data write stage, thereby writing the data voltage on the data line Data to the first electrode of the drive transistor T1. Optionally, the first scan signal line SP1 is disposed in the first conductive layer M1.

Optionally, referring to FIGS. 4 and 6, the driver circuit layer further includes a second scan signal line SP2 electrically connected to the gates of the first initialization transistor T2 and the second initialization transistor T6. The second scan signal line SP2 is configured to control the first initialization transistor T2 and the second initialization transistor T6 to be turned on in a first initialization stage, thereby initializing the first electrode of the drive transistor T1 and the OLED. Optionally, the second scan signal line SP2 is disposed in the first conductive layer M1.

Optionally, referring to FIGS. 4 and 6, the driver circuit layer further includes third scan signal lines SN1 electrically connected to the gate of the third initialization transistor T5. The third scan signal lines SN1 are configured to control the third initialization transistor T5 to be turned on in a second initialization stage, thereby initializing the gate of the drive transistor T1. Optionally, the third scan signal lines SN1 are disposed in the second conductive layer M2 and the third conductive layer M3. Optionally, the third scan signal line SN1 in the second conductive layer M2 and the third scan signal line SN1 in the third conductive layer M3 are connected, for example, connected at a position in a display region adjacent to a bezel region of the display panel.

Optionally, referring to FIGS. 4 and 6, the driver circuit layer further includes fourth scan signal lines SN2 electrically connected to the gate of the threshold compensation transistor T4. The fourth scan signal lines SN2 are configured to control the threshold compensation transistor T4 to be turned on in a threshold compensation stage so that the threshold compensation transistor T4 performs threshold compensation on the drive transistor T1. Optionally, the fourth scan signal lines SN2 are disposed in the third conductive layer M3 and the second conductive layer M2. Optionally, the fourth scan signal line SN2 in the second conductive layer M2 and the fourth scan signal line SN2 in the third conductive layer M3 are connected, for example, connected at a position in the display region adjacent to the bezel region of the display panel.

Optionally, referring to FIG. 9, the first connecting portion 101 includes a first portion 1011 and a second portion 1012 that are connected. The first portion 1011 is electrically connected to the first electrode of the drive transistor T1, the second portion 1012 is electrically connected to the first initialization transistor T2, the first portion 1011 extends along the first direction X, the second portion 1012 extends along the second direction Y, the first direction X and the second direction Y intersect, the overlapping portion 102 exists between the orthographic projection of the second portion 1012 on the substrate 110 and the orthographic projection of the light emission control signal line EM on the substrate 110, and the orthographic projection of the first portion 1011 on the substrate 110 is located on one of the two opposite sides of the orthographic projection of the light emission control signal line EM on the substrate 110 along the second direction Y. In this manner, when the shielding portion 103 shields the overlapping portion 102, the shielding portion 103 does not overlap the via, thereby avoiding damage to the shielding portion 103 or a short circuit connection caused by the via. Optionally, the gap 120 exists between the orthographic projection of the first portion 1011 on the substrate 110 and the orthographic projection of the light emission control signal line EM on the substrate 110. The orthographic projection of the shielding layer M0 on the substrate 110 at least partially overlaps the gap 120 so that the shielding layer M0 can shield some electric field lines, thereby reducing the lateral capacitance.

Optionally, referring to FIG. 14, the first connecting portion 101 includes a first portion 1011, a second portion 1012, and a third portion 1013 connected in sequence. The first portion 1011 is electrically connected to the first electrode of the drive transistor T1, the third portion 1013 is electrically connected to the first initialization transistor T2, the first portion 1011 and the third portion 1013 extend along the first direction X, the second portion 1012 extends along the second direction Y, the first direction X and the second direction Y intersect, an overlapping portion exists between the orthographic projection of the second portion 1012 and the orthographic projection of the light emission control signal line EM on the substrate 110, and the orthographic projections of the first portion 1011 and the third portion 1013 on the substrate 110 are located on the two opposite sides of the orthographic projection of the light emission control signal line EM on the substrate 110 along the second direction Y, respectively. Optionally, the gap 120 exists between the orthographic projection of the first portion 1011 on the substrate 110 and the orthographic projection of the light emission control signal line EM on the substrate 110, and the gap 120 exists between the orthographic projection of the third portion 1013 on the substrate 110 and the orthographic projection of the light emission control signal line EM on the substrate 110.

To facilitate the wiring design, the first connecting portion 101 is configured to be the first portion 1011, the second portion 1012, and the third portion 1013 connected in sequence. For example, the first portion 1011, the second portion 1012, and the third portion 1013 are an integral structure. In this manner, when the shielding portion 103 shields the overlapping portion 102, the shielding portion 103 does not overlap the via, thereby avoiding damage to the shielding portion 103 or a short circuit connection caused by the via. The first portion 1011 and the third portion 1013 have the same extension direction (or extension trend) as the light emission control signal line EM, the gap 120 exists between the orthographic projection of the first portion 1011 on the substrate 110 and the orthographic projection of the light emission control signal line EM on the substrate 110, the gap 120 exists between the orthographic projection of the third portion 1013 on the substrate 110 and the orthographic projection of the light emission control signal line EM on the substrate 110, and the lateral capacitance is easily formed at the gaps 120 due to coupling. In the technical solution of this embodiment, the orthographic projection of the shielding layer M0 on the substrate 110 at least partially overlaps the gaps 120 so that the shielding layer M0 can shield some electric field lines, thereby reducing the lateral capacitance. Moreover, the shielding portion 103 can cover the gaps 120, that is, the orthographic projection of the shielding portion 103 on the substrate 110 at least partially overlaps the gaps 120, thereby further reducing the lateral capacitance.

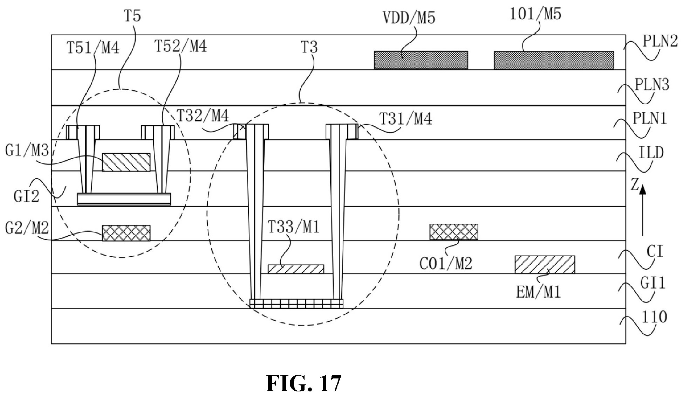

FIG. 17 is another sectional view of FIG. 7 taken along a direction a1-a2. Optionally, referring to FIG. 17, multiple organic insulating layers are disposed between the film where the first connecting portion 101 is located and the film where the light emission control signal line EM is located; and/or the organic insulating layer includes an organic planarization layer; and/or at least one organic insulating layer and at least one inorganic insulating layer are disposed between the film where the first connecting portion 101 is located and the film where the light emission control signal line EM is located and stacked along the thickness direction Z of the substrate 110.

Multiple organic insulating layers are disposed between the film where the first connecting portion 101 is located and the film where the light emission control signal line EM is located so that the dielectric layer thickness between the first connecting portion 101 and the light emission control signal line EM is larger, and the facing distance between the first connecting portion 101 and the light emission control signal line EM is larger, thereby reducing the parasitic capacitance at the overlapping portion 102. Moreover, the multiple organic insulating layers can effectively reduce the dielectric constant of the parasitic capacitor, thereby further reducing the parasitic capacitance at the overlapping portion 102. As shown in FIG. 15, the organic insulating layers include the first organic planarization layer PLN1 and a third organic planarization layer PLN3, the first organic planarization layer PLN1 is located on a side of the third conductive layer M3 facing away from the substrate 110, the third organic planarization layer PLN3 is located on a surface of the first organic planarization layer PLN1 facing away from the substrate 110, and the second organic planarization layer PLN2 is located on a surface of the third organic planarization layer PLN3 facing away from the substrate 110. For example, the third organic planarization layer PLN3 may be an additionally provided organic planarization layer. In this manner, the first organic planarization layer PLN1 and the third organic planarization layer PLN3 can isolate the first connecting portion 101 from the light emission control signal line EM, which is conducive to reducing the parasitic capacitance between the light emission control signal line EM and the first connecting portion 101 and further reducing the influence of the parasitic capacitor on the potential of the first electrode of the drive transistor T1.

At least one organic insulating layer and at least one inorganic insulating layer (for example, one or more of the capacitor insulating layer CI, the second buffer layer B2, the second gate insulating layer GI2, or the interlayer insulating layer ILD) are disposed between the film where the first connecting portion 101 is located and the film where the light emission control signal line EM is located and stacked along the thickness direction Z of the substrate 110, the orthographic projection of one or more organic insulating layers on the substrate 110 overlaps the overlapping portion 102, and the orthographic projection of one or more inorganic insulating layers on the substrate 110 overlaps the overlapping portion 102, thereby further increasing the distance between the first connecting portion 101 and the light emission control signal line EM in the thickness direction Z of the display panel, which is conducive to further reducing the parasitic capacitance between the light emission control signal line EM and the first connecting portion 101. The inorganic insulating layer may include one or more of silicon oxide, silicon nitride, or silicon oxynitride. The organic insulating layer may include one or more of polyimide, polyacrylate, polyetherimide, polyethylene terephthalate, or polyethylene naphthalate.

Optionally, the organic insulating layer is disposed between the film where the first connecting portion 101 is located and the film where the light emission control signal line EM is located, or at least one organic insulating layer and at least one inorganic insulating layer are disposed between the film where the first connecting portion 101 is located and the film where the light emission control signal line EM is located. The thickness D of the insulating layer between the film where the first connecting portion 101 is located and the film where the light emission control signal line EM is located is greater than 2.6 micrometers, that is, the facing distance between the first connecting portion 101 and the light emission control signal line EM at the overlapping part is greater than 2.6 micrometers, thereby reducing the parasitic capacitance between the light emission control signal line EM and the first connecting portion 101. For example, the parasitic capacitance is less than 0.85 fF.

Optionally, only the inorganic insulating layer is disposed between the film where the first connecting portion 101 is located and the film where the light emission control signal line EM is located. The thickness D of the insulating layer (the insulating layer corresponding to the overlapping portion 102) between the film where the first connecting portion 101 is located and the film where the light emission control signal line EM is located is greater than 3 micrometers, that is, the facing distance between the first connecting portion 101 and the light emission control signal line EM at the overlapping part is greater than 3 micrometers, thereby reducing the parasitic capacitance between the light emission control signal line EM and the first connecting portion 101. For example, the parasitic capacitance is less than 0.85 fF.

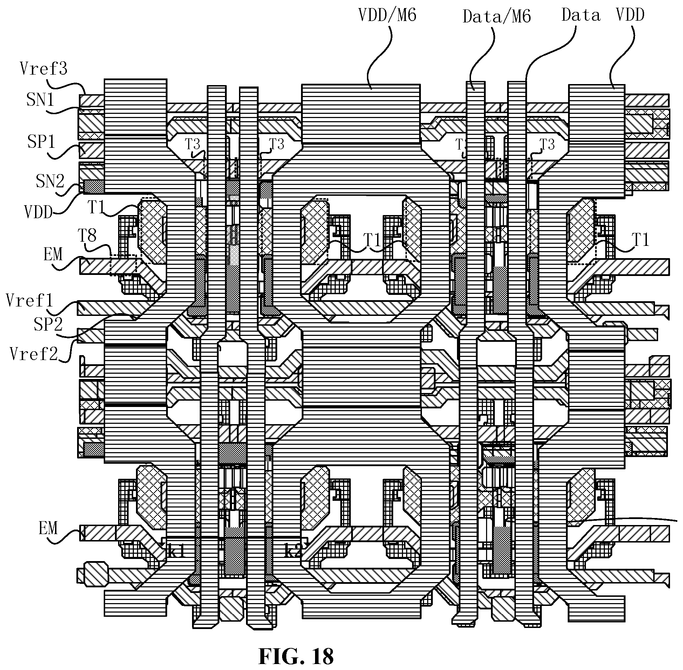

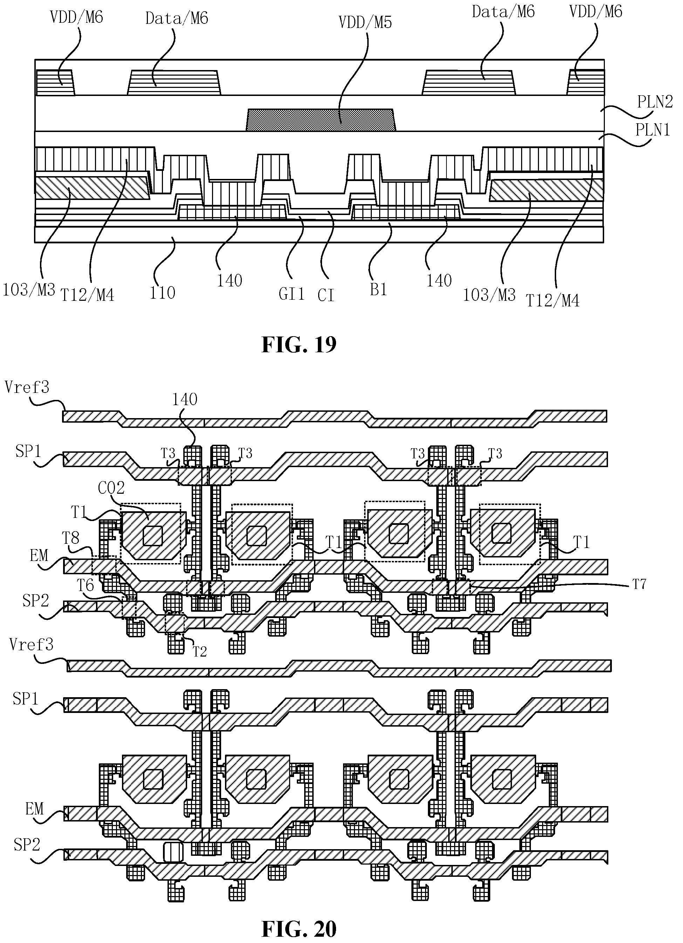

Based on the preceding technical solutions, FIG. 18 is a structural view illustrating the layout of another array substrate according to an embodiment of the present application, and FIG. 19 is a sectional view of FIG. 18 taken along a direction k1-k2. Referring to FIGS. 18 and 19, optionally, the driver circuit layer further includes the sixth conductive layer M6, the sixth conductive layer M6 is located on a side of the fifth conductive layer M5 facing away from the substrate 110, and the sixth conductive layer M6 includes the first power supply line VDD and the data line Data. The first power supply line VDD provides a first power supply voltage for the pixel circuit, and the data line Data is configured to provide a data voltage for the pixel circuit so that the pixel circuit generates the drive current according to the data voltage and the first power supply voltage.

As shown in FIG. 19, the fourth conductive layer M4 further includes the first electrode of the drive transistor T1 (for example, the source of the drive transistor T1).

Optionally, in some embodiments, after the routing of the first power supply line VDD and the data line Data is completed, if space for disposing the first connecting portion 101 exists in the sixth conductive layer M6, the first connecting portion 101 may be disposed in the sixth conductive layer M6. In this manner, the facing distance between the first connecting portion 101 and the light emission control signal line EM can be further increased, and the parasitic capacitance generated by the coupling between the first connecting portion 101 and the light emission control signal line EM can be further reduced, thereby ensuring the stability of the potential of the first electrode of the drive transistor T1 and thus ensuring the stability of the drive current generated by the drive transistor T1. The organic insulating layer may be disposed between the fifth conductive layer M5 and the sixth conductive layer M6. The sixth conductive layer M6 may include one or more of a metal layer, an ITO layer, or the like.

When the first connecting portion 101 is disposed in the sixth conductive layer M6, the shielding portion 103 may be disposed in the third conductive layer M3, the fourth conductive layer M4, or the fifth conductive layer M5. When the shielding portion 103 is disposed in the fifth conductive layer M5, the shielding portion 103 may be connected to the first power supply line VDD in the fifth conductive layer M5 so that the shielding portion 103 is connected to a direct current potential, which is conducive to better shielding the light emission control signal line EM from the first connecting portion 101.

Based on the preceding technical solutions, the structures of multiple films in the array substrate are described below, which is not intended to limit the present application.

FIG. 20 is a structural view illustrating the layout of a first conductive layer and a second active layer of an array substrate according to an embodiment of the present application. Optionally, referring to FIG. 20, the first conductive layer M1 includes the light emission control signal line EM, the first scan signal line SP1, the second scan signal line SP2, a third initialization signal line Vref3, and a second electrode plate C02 of the storage capacitor Cst (that is, the gate of the drive transistor T1), and the extension direction (or extension trend) of the light emission control signal line EM, the first scan signal line SP1, the second scan signal line SP2, and the third initialization signal line Vref3 is the first direction X.

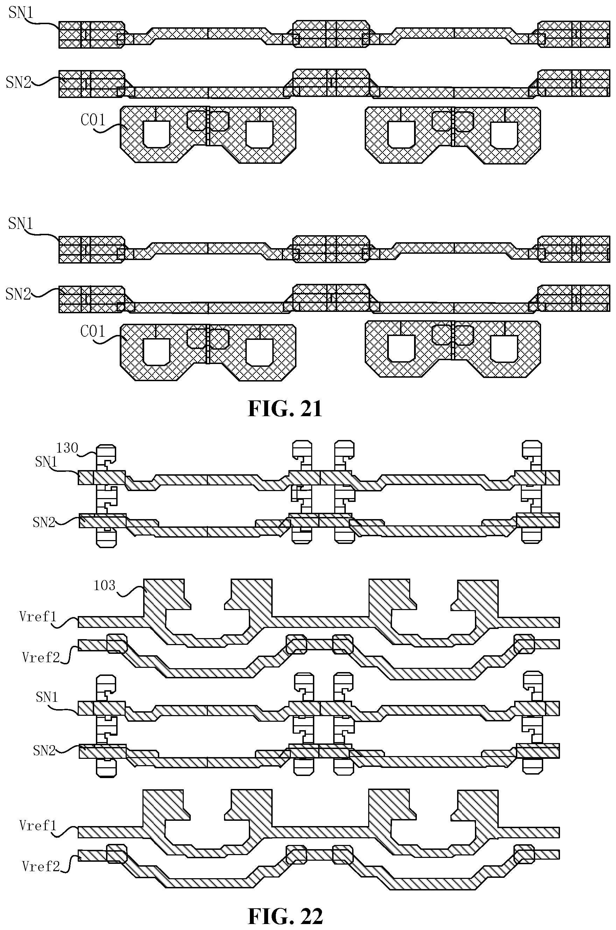

FIG. 21 is a structural view illustrating the layout of a second conductive layer of an array substrate according to an embodiment of the present application. Optionally, referring to FIG. 21, the second conductive layer M2 includes the first electrode plate C01 of the storage capacitor Cst, the third scan signal line SN1, and the fourth scan signal line SN2, and the extension direction (or extension trend) of the third scan signal line SN1 and the fourth scan signal line SN2 is the first direction X. A bottom gate of the third initialization transistor T5 may be formed in an overlapping region between the first active layer 130 and the third scan signal line SN1 in the second conductive layer M2. A bottom gate of the threshold compensation transistor T4 may be formed in an overlapping region between the first active layer 130 and the fourth scan signal line SN2 in the second conductive layer M2.

FIG. 22 is a structural view illustrating the layout of a third conductive layer and a first active layer of an array substrate according to an embodiment of the present application. Optionally, referring to FIG. 22, the third conductive layer M3 includes the first initialization signal line Vref1, the second initialization signal line Vref2, the third scan signal line SN1, and the fourth scan signal line SN2, and the extension direction (or extension trend) of the first initialization signal line Vref1, the second initialization signal line Vref2, the third scan signal line SN1, and the fourth scan signal line SN2 is the first direction X. A top gate of the third initialization transistor T5 may be formed in an overlapping region between the first active layer 130 and the third scan signal line SN1 in the third conductive layer M3. A top gate of the threshold compensation transistor T4 may be formed in an overlapping region between the first active layer 130 and the fourth scan signal line SN2 in the third conductive layer M3.

The third scan signal line SN1 in the second conductive layer M2 and the third scan signal line SN1 in the third conductive layer M3 are electrically connected, for example, through a via. The fourth scan signal line SN2 in the second conductive layer M2 and the fourth scan signal line SN2 in the third conductive layer M3 are electrically connected, for example, through a via. In this manner, the bottom gate and the top gate of the threshold compensation transistor T4 can be connected, and the bottom gate and the top gate of the third initialization transistor T5 can be connected.

FIG. 22 shows the case where the shielding portion 103 is in the third conductive layer M3 and the shielding portion 103 is electrically connected to the first initialization signal line Vref1, which is not limited thereto.

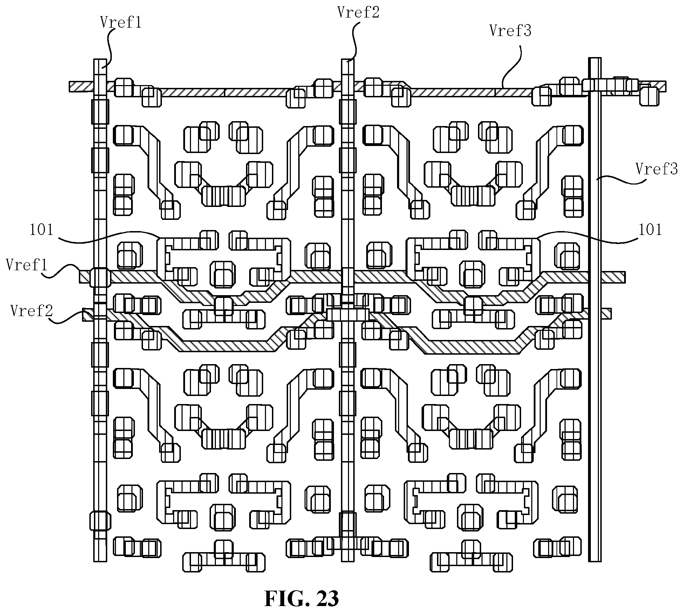

FIG. 23 is a structural view illustrating the layout of a fourth conductive layer of an array substrate according to an embodiment of the present application. Optionally, referring to FIG. 23, the fourth conductive layer M4 includes the first connecting portion 101, the first initialization signal line Vref1, the second initialization signal line Vref2, and the third initialization signal line Vref3, and the extension direction (or extension trend) of the first initialization signal line Vref1, the second initialization signal line Vref2, and the third initialization signal line Vref3 is the second direction Y. As shown in FIG. 22, the first initialization signal lines Vref1 (extending along the first direction X) located in the third conductive layer M3 and the first initialization signal lines Vref1 (extending along the second direction Y) located in the fourth conductive layer M4 form a mesh structure, thereby making the first initialization signals transmitted by the first initialization signal lines Vref1 to different positions (in different pixel circuits) substantially uniform, which is conducive to improving the display uniformity of the display panel. Similarly, the second initialization signal lines Vref2 (extending along the first direction X) located in the third conductive layer M3 and the second initialization signal lines Vref2 (extending along the second direction Y) located in the fourth conductive layer M4 form a mesh structure, and the third initialization signal lines Vref3 (extending along the first direction X) located in the first conductive layer M1 and the third initialization signal lines Vref3 (extending along the second direction Y) located in the fourth conductive layer M4 form a mesh structure, which is conducive to improving the display uniformity of the display panel. The first power supply lines (extending along the first direction X) located in the fifth conductive layer M5 and the first power supply lines (extending along the second direction Y) located in the sixth conductive layer M6 form a mesh structure.

Each signal line may extend in a linear shape, a polyline shape, a curved shape, or other irregular shapes (such as a branch-like shape) along the extension direction (the general extension direction or extension trend).

Optionally, the shielding portion 103 may be electrically connected to the third initialization signal line Vref3 so that the shielding portion 103 is connected to a direct current potential. Among the first initialization signal line Vref1, the second initialization signal line Vref2, and the third initialization signal line Vref3 extending along the first direction X and corresponding to the pixel circuits in the same row, the orthographic projection of the third initialization signal line Vref3 on the substrate 110 is located on a side of the orthographic projection of the shielding portion 103 on the substrate 110 facing away from the orthographic projections of the first initialization signal line Vref1 and the second initialization signal line Vref2 on the substrate 110. The first initialization signal line Vref1 and the second initialization signal line Vref2 are closer to the shielding portion 103 than the third initialization signal line Vref3. Therefore, electrically connecting the shielding portion 103 to the first initialization signal line Vref1 or the second initialization signal line Vref2 facilitates wiring.

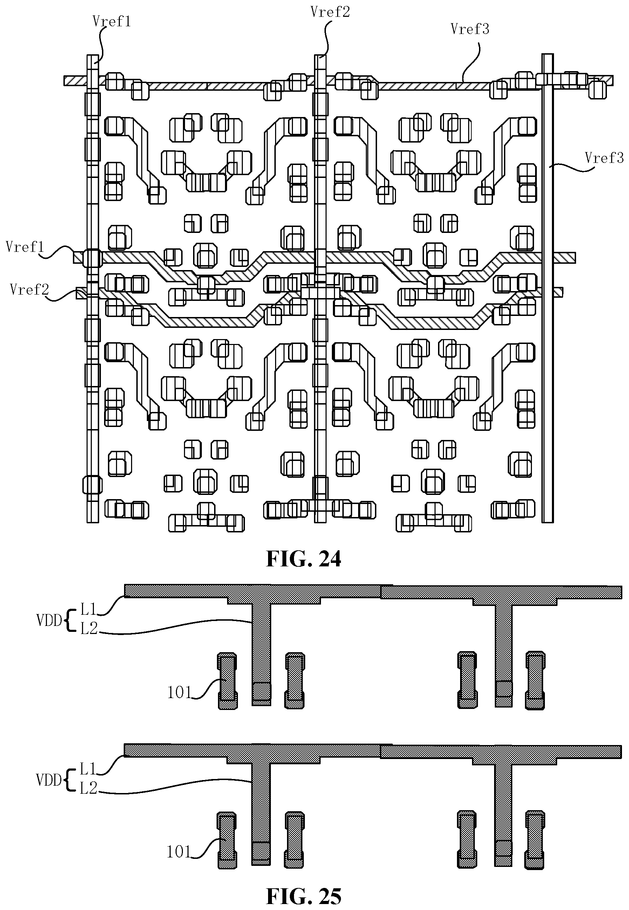

FIG. 24 is a structural view illustrating the layout of a fourth conductive layer of another array substrate according to an embodiment of the present application. Optionally, referring to FIG. 24, when the first connecting portion 101 is disposed on a side of the fourth conductive layer M4 facing away from the substrate 110, the first connecting portion 101 is not disposed in the fourth conductive layer M4.

FIG. 25 is a structural view illustrating the layout of a fifth conductive layer of an array substrate according to an embodiment of the present application. Optionally, referring to FIG. 25, the fifth conductive layer M5 includes the first power supply line VDD with an extension direction (or extension trend) of the first direction X, the first sub-line L1 serves as a body portion, and the second sub-line L2 serves as a branch portion. FIG. 25 shows the case where the first connecting portion 101 is in the fifth conductive layer M5, which is not limited thereto.

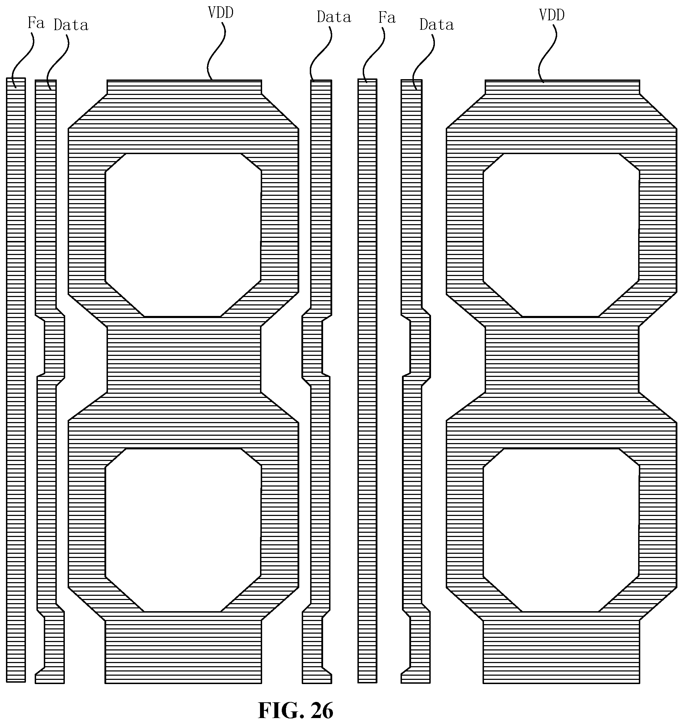

FIG. 26 is a structural view illustrating the layout of a sixth conductive layer of an array substrate according to an embodiment of the present application. Optionally, referring to FIG. 26, the sixth conductive layer M6 includes the first power supply lines VDD with an extension direction (or extension trend) of the second direction Y and the data lines Data with an extension direction (or extension trend) of the second direction Y.

Optionally, as shown in FIG. 26, the sixth conductive layer M6 further includes data connection lines Fa, each of which is configured to connect the driver chip to the data line Data. The data connection lines Fa are disposed in the sixth conductive layer M6 so that the wires in the bezel region (non-display region) of the display panel can be reduced, which is conducive to achieving a narrow bezel.

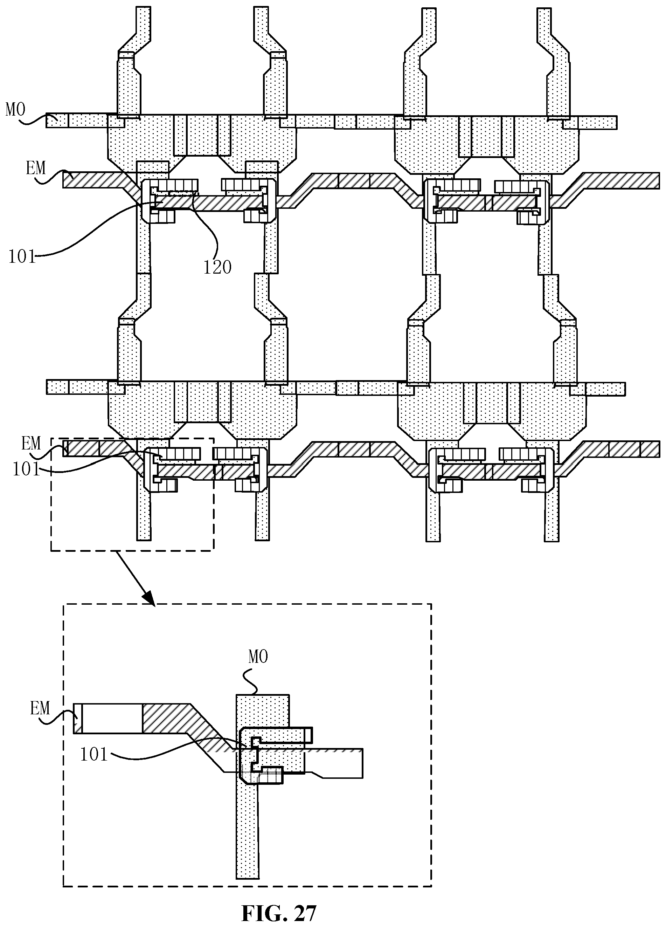

FIG. 27 is a structural view illustrating the layout of a shielding layer of an array substrate according to an embodiment of the present application. Optionally, referring to FIG. 27, the orthographic projection of the shielding layer M0 on the substrate 110 at least partially overlaps the gap 120.

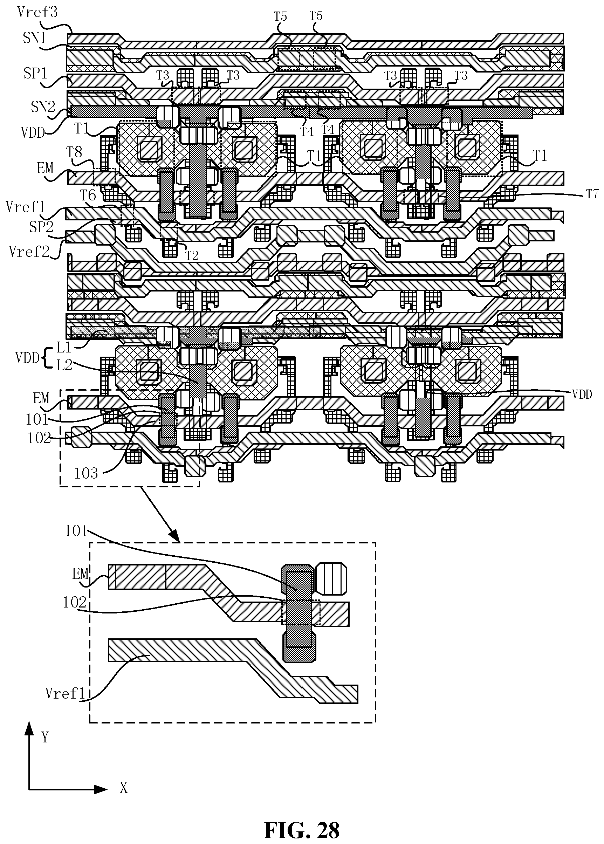

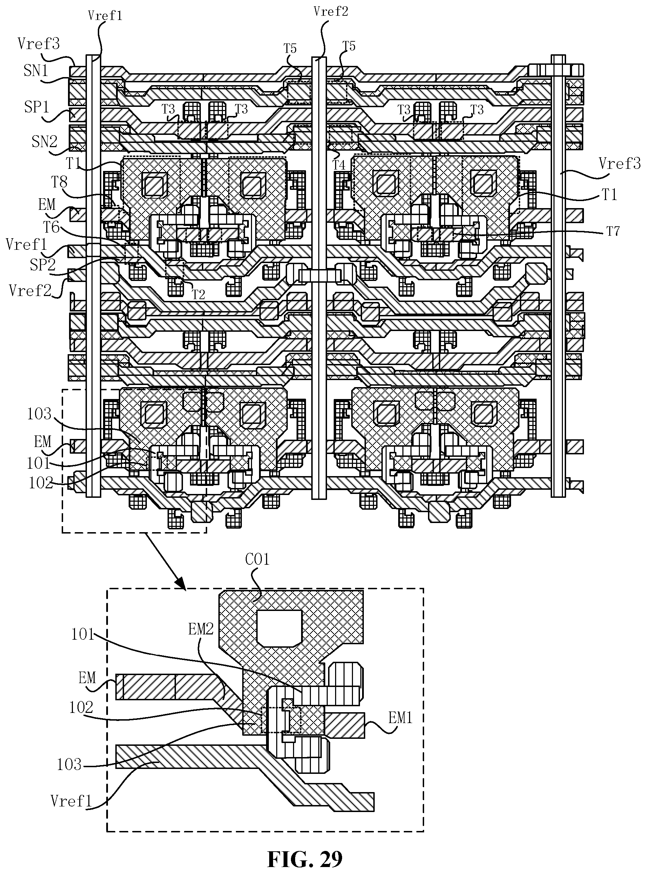

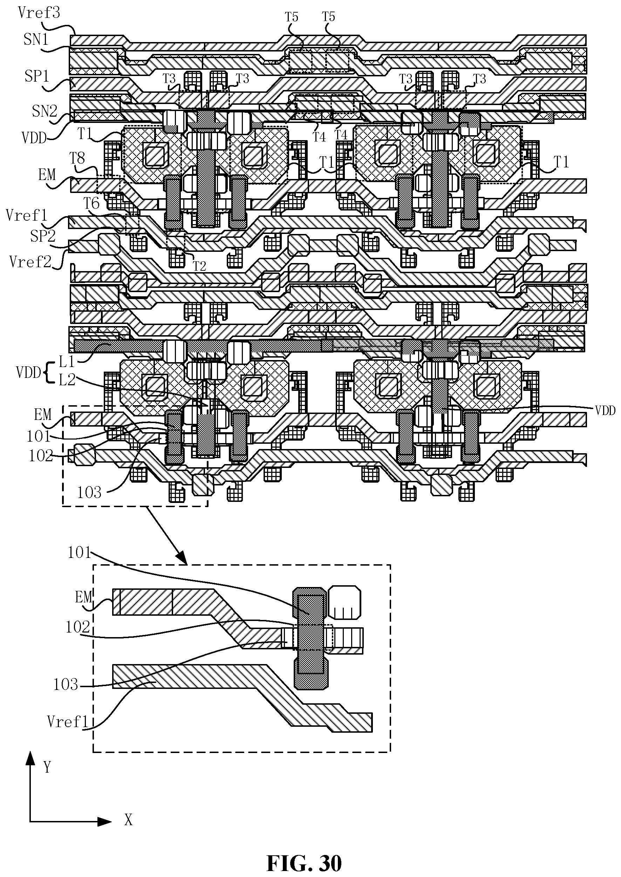

FIG. 28 is a structural view illustrating the layout of another array substrate according to an embodiment of the present application. FIG. 28 shows the case where the first connecting portion 101 is located in the fifth conductive layer M5. FIG. 29 is a structural view illustrating the layout of another array substrate according to an embodiment of the present application. FIG. 29 shows the case where the first connecting portion 101 is located in the fourth conductive layer M4 and the shielding portion 103 is electrically connected to the first electrode plate C01 of the storage capacitor Cst. FIG. 30 is a structural view illustrating the layout of another array substrate according to an embodiment of the present application. FIG. 30 shows the case where the first connecting portion 101 is located in the fifth conductive layer M5 and the shielding portion 103 is located in the fourth conductive layer M4. Optionally, referring to FIGS. 28 to 30, the orthographic projection of the first initialization signal line Vref1 on the substrate 110 and the orthographic projection of the light emission control signal line EM on the substrate 110 are separated, that is, the orthographic projections do not overlap.

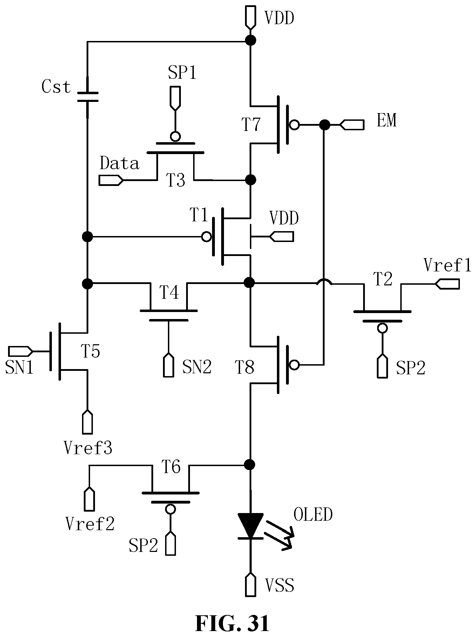

Optionally, FIG. 31 is a structural diagram of another pixel circuit according to an embodiment of the present application. The pixel circuit further includes the first light emission control transistor T7 connected between the second electrode of the drive transistor T1 and the first power supply line VDD, and the gate of the first light emission control transistor T7 is electrically connected to the light emission control signal line EM; and/or the pixel circuit further includes the second light emission control transistor T8 connected between the first electrode of the drive transistor T1 and the first terminal of the OLED, and the gate of the second light emission control transistor T8 is electrically connected to the light emission control signal line EM; and/or the pixel circuit further includes the data write transistor T3 connected between the data line Data and the second electrode of the drive transistor T1; and/or the pixel circuit further includes the storage capacitor Cst connected between the first power supply line VDD and the gate of the drive transistor T1. Optionally, the pixel circuit further includes the threshold compensation transistor T4 connected between the gate and the first electrode of the drive transistor T1.

The difference between the circuit structure in FIG. 31 and the circuit structure in FIG. 6 is the difference in the connection position of the first initialization transistor T2. That is, in FIG. 31, the first initialization transistor T2 is connected to the drain of the drive transistor T1, while in FIG. 6, the first initialization transistor T2 is connected to the source of the drive transistor T1. Corresponding components in the circuit structure in FIG. 31 and the circuit structure in FIG. 6 have the same or similar structures and functions, and the details are not repeated here. In FIG. 31, the first electrode of the drive transistor T1 is equivalent to the drain, and the second electrode of the drive transistor T1 is equivalent to the source. In FIG. 6, the first electrode of the drive transistor T1 is equivalent to the source, and the second electrode of the drive transistor T1 is equivalent to the drain.

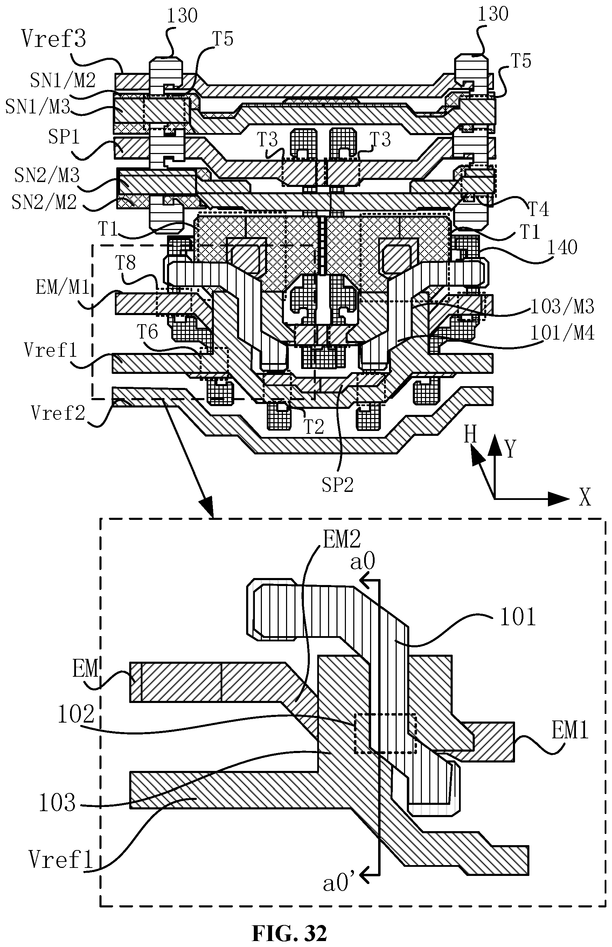

FIG. 32 is a structural view illustrating the layout of another array substrate according to an embodiment of the present application. The layout structure in FIG. 32 corresponds to the circuit in FIG. 31. The circuit in FIG. 6 corresponds to the layout and film structures in FIGS. 4 to 30. The end of the first connecting portion 101 connected to the drive transistor T1 in the layout and film structures corresponding to the circuit in FIG. 6 is changed from being connected to the source of the drive transistor to being connected to the drain of the drive transistor, and the corresponding components such as the shielding portion 103 have the same or similar positions and functions. The details are not repeated here. In the pixel circuits (such as the circuit in FIG. 6 and the circuit in FIG. 31), PWM technology may be used for dimming. The light emission control signal in a light emission stage within a frame refresh period may include multiple pulses. Timing waveform diagrams and operating processes of the circuit in FIG. 6 and the circuit in FIG. 31 are the same as or similar to those in FIGS. 1 and 2, and the details are not repeated here.

Optionally, the first light emission control transistor T7 is connected between the second electrode of the drive transistor T1 and the second sub-line L2.

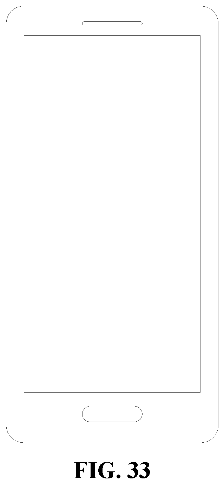

This embodiment further provides a display panel. FIG. 33 is a structural view of a display panel according to an embodiment of the present application. As shown in FIG. 33, the display panel includes the array substrate provided in any of the preceding embodiments. The display panel may be any product or component with a display function, such as a mobile phone, a tablet computer, a television, a display, a laptop, or a digital photo frame. The display panel includes the array substrate provided in any embodiment of the present application, and therefore has the same beneficial effects as the array substrate provided in any embodiment of the present application. The details are not repeated here.

The preceding embodiments do not limit the scope of the present application. It is to be understood by those skilled in the art that various modifications, combinations, sub-combinations, and substitutions may be made according to design requirements and other factors. Any modification, equivalent substitution, improvement or the like made within the spirit and principle of the present application is within the scope of the present application.

## Claims

1. An array substrate, comprising a substrate and a driver circuit layer located on the substrate, wherein a pixel circuit and a light emission control signal line are disposed in the driver circuit layer, the pixel circuit comprises a drive transistor, a first initialization transistor, and a first connecting portion, the first connecting portion is connected between a first electrode of the drive transistor and the first initialization transistor, and an overlapping portion exists between an orthographic projection of the first connecting portion on the substrate and an orthographic projection of the light emission control signal line on the substrate;
the driver circuit layer is further provided with a shielding portion, an orthographic projection of the shielding portion on the substrate overlaps the overlapping portion, and a film where the shielding portion is located is between a film where the light emission control signal line is located and a film where the first connecting portion is located;
and/or, at least one organic insulating layer is disposed between a film where the first connecting portion is located and a film where the light emission control signal line is located;
and/or, a thickness of an insulating layer between a film where the first connecting portion is located and a film where the light emission control signal line is located is greater than 3 micrometers.

2. The array substrate of claim 1, wherein the shielding portion is connected to a direct current potential.

3. The array substrate of claim 1, wherein the driver circuit layer is further provided with a first power supply line and an initialization signal line, and the shielding portion is electrically connected to the first power supply line or the initialization signal line.

4. The array substrate of claim 1, wherein
the driver circuit layer comprises a first conductive layer, a second conductive layer, a third conductive layer, a fourth conductive layer, and a fifth conductive layer that are stacked;
the light emission control signal line is disposed in the first conductive layer;
the pixel circuit further comprises a storage capacitor, and a first electrode plate of the storage capacitor is disposed in the second conductive layer;
the pixel circuit further comprises a switching transistor connected to a gate of the drive transistor, and a first gate of the switching transistor is disposed in the third conductive layer;
the first connecting portion is disposed in the fourth conductive layer, or on a side of the fourth conductive layer facing away from the substrate; and
the fifth conductive layer is provided with a first power supply line configured to provide a first power supply voltage for the pixel circuit.

5. The array substrate of claim 4, wherein
the first connecting portion is disposed in the fifth conductive layer;
an organic insulating layer is disposed between the fourth conductive layer and the fifth conductive layer; and
an inorganic insulating layer is disposed between any two adjacent ones of the first conductive layer, the second conductive layer, the third conductive layer, and the fourth conductive layer.

6. The array substrate of any one of claims 1 to 5, wherein
the overlapping portion is located within the orthographic projection of the shielding portion on the substrate; and
the film where the light emission control signal line is located, the film where the shielding portion is located, and the film where the first connecting portion is located are sequentially stacked along a direction away from the substrate.

7. The array substrate of any one of claims 1 to 5, wherein the pixel circuit further comprises a second initialization transistor, the driver circuit layer is further provided with a first initialization signal line and a second initialization signal line, the first initialization transistor is connected between the first initialization signal line and the first electrode of the drive transistor, and the second initialization transistor is connected between the second initialization signal line and a first terminal of a light-emitting device;
the shielding portion is electrically connected to the first initialization signal line or the second initialization signal line; and
a gate of the first initialization transistor and a gate of the second initialization transistor are electrically connected to a same scan signal line.

8. The array substrate of claim 7, wherein the driver circuit layer further comprises a third conductive layer, and the pixel circuit further comprises a switching transistor;
the switching transistor is connected to a gate of the drive transistor, and the third conductive layer is provided with a first gate of the switching transistor;
the shielding portion is disposed in the third conductive layer;
the first initialization signal line and/or the second initialization signal line are disposed in the third conductive layer;
an orthographic projection of the first initialization signal line on the substrate is located between an orthographic projection of the second initialization signal line on the substrate and the orthographic projection of the shielding portion on the substrate; and the orthographic projection of the first initialization signal line on the substrate is located between the orthographic projection of the second initialization signal line on the substrate and the orthographic projection of the light emission control signal line on the substrate;
the first initialization signal line, the second initialization signal line, and the light emission control signal line extend in a first direction and are arranged along a second direction, wherein the first direction and the second direction intersect;
the second initialization signal line is electrically connected to the shielding portion through a second connecting portion, and the second connecting portion and the first initialization signal line intersect and are insulated from each other;
a film where the second connecting portion is located is on a side of a film where the first initialization signal line is located facing away from the substrate; and
the first connecting portion and the second connecting portion are disposed in a same layer.

9. The array substrate of any one of claims 1 to 5, wherein the pixel circuit further comprises a storage capacitor, and a first electrode plate of the storage capacitor is connected to a first power supply line;
the first electrode plate and the shielding portion are electrically connected to form an integral structure and are disposed in a same layer;
the driver circuit layer further comprises a second conductive layer in which the first electrode plate of the storage capacitor is disposed; and
a second electrode plate of the storage capacitor is reused as a gate of the drive transistor.

10. The array substrate of any one of claims 1 to 5, wherein
the driver circuit layer is provided with a first power supply line, the first power supply line comprises a first sub-line and a second sub-line that are electrically connected, and the pixel circuit further comprises a first light emission control transistor electrically connected to the second sub-line;
the second sub-line is electrically connected to the shielding portion;
the shielding portion extends along a first direction, the first sub-line extends along the first direction, an extension direction of the second sub-line intersects with the first direction, and the first sub-line and the second sub-line are disposed in a same layer;
the first light emission control transistor is connected between the first electrode of the drive transistor and the second sub-line, or the first light emission control transistor is connected between a second electrode of the drive transistor and the second sub-line;
a gate of the first light emission control transistor is electrically connected to the light emission control signal line; and
the driver circuit layer further comprises a fourth conductive layer and a fifth conductive layer, the shielding portion is disposed in the fourth conductive layer, the first sub-line and the second sub-line are disposed in the fifth conductive layer, and the second sub-line is electrically connected to the shielding portion through a via.

11. The array substrate of claim 10, wherein among three adjacent pixel circuits along a first direction, the shielding portion in a pixel circuit located in the middle is connected to the shielding portion in a pixel circuit located on one side, and a distance between the first connecting portion in the pixel circuit located in the middle and the first connecting portion in a pixel circuit located on one side is less than a distance between the first connecting portion in the pixel circuit located in the middle and the first connecting portion in a pixel circuit located on another side; and
two adjacent pixel circuits along the first direction are arranged in a mirror-symmetrical manner.

12. The array substrate of claim 1, wherein the light emission control signal line comprises a body portion extending along a first direction and an extension portion extending along a third direction, the first direction and the third direction intersect, and the orthographic projection of the shielding portion on the substrate at least partially covers an orthographic projection of the extension portion on the substrate.

13. The array substrate of claim 1, wherein the array substrate further comprises a shielding layer located between the substrate and the driver circuit layer;
a gap exists between an orthographic projection of the first connecting portion on the substrate and the orthographic projection of the light emission control signal line on the substrate;
an orthographic projection of the shielding layer on the substrate at least partially overlaps the gap;
at least part of the shielding layer is connected to a direct current potential;
the shielding layer is electrically connected to a first power supply line;
an orthographic projection of the shielding layer on the substrate overlaps at least part of an active portion of a channel region of the drive transistor; and
the shielding layer is an electrostatic shielding layer and/or a light-shielding layer.

14. The array substrate of any one of claims 1 to 5, wherein the driver circuit layer is further provided with a first initialization signal line, and the first initialization transistor is connected between the first initialization signal line and the first electrode of the drive transistor; and
the first initialization signal line and the light emission control signal line extend along a first direction and are arranged along a second direction, an orthographic projection of the first initialization signal line on the substrate and the orthographic projection of the light emission control signal line on the substrate are separated, and the first direction and the second direction intersect.

15. The array substrate of claim 14, wherein the shielding portion and the first initialization signal line are electrically connected to form an integral structure and are disposed in a same layer;
the shielding portion is located on one side of two opposite sides of the first initialization signal line along the second direction;
the driver circuit layer further comprises a first active layer, a third conductive layer, a second active layer, and a first conductive layer, an active portion of the drive transistor is located in the second active layer, a gate of the drive transistor is located in the first conductive layer, and the first initialization signal line is located in the third conductive layer or on a side of the third conductive layer facing away from the substrate;
the pixel circuit further comprises a threshold compensation transistor connected between the gate and a second electrode of the drive transistor or connected between the gate and the first electrode of the drive transistor, an active portion of the threshold compensation transistor is located in the first active layer, and a gate of the threshold compensation transistor is located in the third conductive layer;
the pixel circuit further comprises a third initialization transistor electrically connected to the gate of the drive transistor, an active portion of the third initialization transistor is located in the first active layer, and a gate of the third initialization transistor is located in the third conductive layer; and the second active layer comprises polysilicon, and the first active layer comprises metal oxide.

16. The array substrate of claim 1, wherein the pixel circuit further comprises:
a first light emission control transistor connected between the first electrode of the drive transistor and a first power supply line, wherein a gate of the first light emission control transistor is electrically connected to the light emission control signal line;
a second light emission control transistor connected between a second electrode of the drive transistor and a first terminal of a light-emitting device, wherein a gate of the second light emission control transistor is electrically connected to the light emission control signal line;
a data write transistor connected between a data line and the first electrode of the drive transistor; and
a storage capacitor connected between the first power supply line and a gate of the drive transistor;
or the pixel circuit further comprises:
a first light emission control transistor connected between a second electrode of the drive transistor and a first power supply line, wherein a gate of the first light emission control transistor is electrically connected to the light emission control signal line;
a second light emission control transistor connected between the first electrode of the drive transistor and a first terminal of a light-emitting device, wherein a gate of the second light emission control transistor is electrically connected to the light emission control signal line;
a data write transistor connected between a data line and the second electrode of the drive transistor; and
a storage capacitor connected between the first power supply line and a gate of the drive transistor.

17. The array substrate of claim 1 or claim 15, wherein the first connecting portion comprises a first portion, a second portion, and a third portion connected in sequence, the first portion is electrically connected to the first electrode of the drive transistor, the third portion is electrically connected to the first initialization transistor, the first portion and the third portion extend along a first direction, the second portion extends along a second direction, the first direction and the second direction intersect, the overlapping portion exists between an orthographic projection of the second portion on the substrate and the orthographic projection of the light emission control signal line on the substrate, orthographic projections of the first portion and the third portion on the substrate are located on two opposite sides of the orthographic projection of the light emission control signal line on the substrate along a second direction, respectively, a gap exists between an orthographic projection of the first portion on the substrate and the orthographic projection of the light emission control signal line on the substrate, and a gap exists between an orthographic projection of the third portion on the substrate and the orthographic projection of the light emission control signal line on the substrate.

18. The array substrate of any one of claims 1 to 5, wherein a plurality of organic insulating layers are disposed between the film where the first connecting portion is located and the film where the light emission control signal line is located;
and/or, an organic insulating layer of the at least one organic insulating layer comprises an organic planarization layer;
and/or, at least one organic insulating layer and at least one inorganic insulating layer are disposed between the film where the first connecting portion is located and the film where the light emission control signal line is located and stacked along a thickness direction of the substrate;
and/or, an organic insulating layer is disposed between the film where the first connecting portion is located and the film where the light emission control signal line is located, and a thickness of an insulating layer between the film where the first connecting portion is located and the film where the light emission control signal line is located is greater than 2.6 micrometers.

19. substrate of any one of claims 1 to 5, wherein an inorganic insulating layer is disposed between the film where the first connecting portion is located and the film where the light emission control signal line is located and no organic insulating layer is disposed between the film where the first connecting portion is located and the film where the light emission control signal line is located, and a thickness of an insulating layer between the film where the first connecting portion is located and the film where the light emission control signal line is located is greater than 3 micrometers.

20. A display panel, comprising the array substrate of any one of claims 1 to 19.
